# FASCICULE DE BREVET EUROPEEN

(11) **EP 0 897 655 B1**
(45) Date de publication et mention de la délivrance du brevet: **19.07.2000**
(21) Numéro de dépôt: 97917980.1
(22) Date de dépôt: 12.05.1997
(51) Int. Cl.: H05K 7/10, H01R 13/24

(54) **SOCLE DE CONNEXION**
SOCKELKONTAKT
CONNECTION BASE

(30) Priorité: 10.05.1996 CH 120296; 15.01.1997 CH 7397
(43) Date de publication de la demande: 24.02.1999
(73) Titulaire: E-tec AG, CH-2543 Lengnau (CH)
(72) Inventeur: AFFOLTER, Hugo, CH-2543 Lengnau (CH); HAFFTER, Christoph, CH-1084 Carrouge (CH)
(74) Mandataire: Saam, Christophe
(86) Numéro de dépôt international: CH9700184
(87) Numéro de publication internationale: WO9743885

(56) Documents cités:
- DE-A- 3 832 410
- FR-A- 2 214 179
- FR-A- 2 635 616
- GB-A- 1 493 554
- US-A- 4 508 405
- US-A- 4 729 166
- US-A- 4 904 213
- US-A- 5 500 605
- PATENT ABSTRACTS OF JAPAN vol. 096, no. 012, 26 Décembre 1996 & JP 08 203644 A (NHK SPRING CO LTD)

## Description

La présente invention concerne un socle permettant de fixer de manière amovible un deuxième composant électrique comportant une pluralité de pattes de connexion disposées sous forme de matrice, par exemple un circuit intégré du type ball grid array (BGA), column grid array (CGA), land grid array (LGA) ou flip-chip sur un premier composant électrique, par exemple une plaque de circuit imprimé. La présente invention concerne cependant aussi des socles permettant d'effectuer des connexions carte-à-carte entre cartes de circuit imprimé.

La technologie et les méthodes de production de circuits intégrés se sont améliorées constamment au cours des dernières années. En dépit de l'amélioration constante de la résolution utilisée pour la fabrication, on assiste aussi à une augmentation de leur surface. Un problème important posé par cette évolution de la complexité des circuits intégrés est celui de la connexion avec les autres composants. Actuellement, le nombre de pattes nécessaires peut excéder facilement 600. Parallèlement, la distance entre les pattes tend à se réduire constamment. Un écartement des pattes de 0,5 mm est aujourd'hui courant, tandis que l'on voit déjà apparaître des écartements de pattes de 0,4 et même 0,3 mm.

De tels circuits VLSI peuvent s'avérer très coûteux, particulièrement lorsqu'il s'agit de microprocesseurs utilisés en technologie informatique. On a par conséquent imaginé des socles de connexion qui peuvent être soudés sur les pistes d'une carte de circuit imprimé en lieu et place du circuit intégré. Ces socles de connexion sont prévus de manière à ce qu'un circuit intégré puisse être enfiché et retiré ou remplacé aisément et à n'importe quel moment. En particulier, un but de ces socles est de permettre le remplacement d'un circuit intégré comportant un grand nombre de pattes sans risque de pliage des pattes ou de destruction des pistes ou des autres composants du circuit imprimé lors du dessoudage.

Les circuits de type Pin Grid Array (PGA) tendent à se répandre de plus en plus à côté des circuits traditionnels de type PLCC. Des socles de montage adaptés aux circuits PGA comportent un grand nombre de tiges de contact disposées de la même manière que les connecteurs du circuit intégré. Une extrémité des tiges de contact est prévue pour être insérée et soudée dans le masque de trou du circuit imprimé tandis que l'autre extrémité est configurée sous forme de connecteur femelle muni d'un clip et apte à recevoir et à établir un contact électrique avec le connecteur correspondant du circuit intégré.

Ce type de socle de montage nécessite malheureusement une force considérable pour insérer et retirer des circuits intégrés comportant un grand nombre de pattes. On risque ainsi d'endommager le circuit intégré. De surcroît, le centrage du circuit au-dessus du socle n'est pas toujours aisé, en sorte que les pattes du circuit intégré peuvent se plier ou même se casser si l'on essaie de l'insérer alors qu'il est mal centré.

Le problème de la connexion se pose également avec des circuits montés en surface, selon la technologie dite SMD. On connaît par exemple des circuits dont les pattes sont disposées sous forme de matrice (Grid Array), les pattes présentant une forme de portion de sphère, de préférence de demi-sphère. Cette configuration est connue sous la dénomination Ball Grid Array (BGA), ou, chez Motorola, OMPAC (Overmold Plastic Pad Array Carrier). Elle est décrite par exemple dans la revue allemande Megalink, N° 13-1995, respectivement 17-1995, dans une série d'articles par Bernard Schuch intitulés "Ball Grid Arrays (1)", respectivement "Ball Grid Arrays (2)". Les pattes de ces circuits intégrés sont directement soudées avec les surfaces de contact du circuit imprimé. Il est très difficile ensuite de retirer et de remplacer un circuit intégré, en cas par exemple de défaut, sans risquer la destruction du circuit imprimé. Le taux de déchet de tels circuits imprimés qui ne peuvent ensuite plus être utilisés est par conséquent important.

D'autres type de configuration de connecteurs pour circuits intégrés ont encore été imaginés. Les circuits de type Column Grid Array (CGA) sont similaires aux circuits BGA, mais comportent des pattes en forme de colonnettes plutôt qu'en forme de section de sphère. On connaît aussi les circuits de type Land Grid Array (LGA) ou d'autres encore dans lesquels le problème du montage sur le circuit imprimé se pose de manière similaire.

Un but de la présente invention est de proposer un socle de connexion permettant de monter un circuit intégré, par exemple de l'un des types ci-dessus, de manière amovible sur une plaque de circuit imprimé. Un contact fiable doit être garanti même lorsque le nombre de pattes de connexion est très grand, et la force à appliquer pour insérer ou retirer le circuit doit être suffisamment réduite pour exclure tout risque de destruction du circuit intégré.

Un autre but de l'invention est de garantir un contact électrique de bonne qualité et homogène avec toutes les broches du socle.

Selon un autre but de l'invention, les dimensions et en particulier l'épaisseur du socle doivent être aussi réduites que possible afin de permettre son utilisation également dans des dispositifs miniaturisés.

Selon un autre but de l'invention, la construction doit être simplifiée ou optimisée pour permettre une production à un coût moindre, notamment en cas de production en grandes séries.

Un autre but de l'invention est de proposer un socle permettant d'effectuer des connexions carte-à-carte entre différents circuits imprimés. Par la suite, à chaque fois qu'il sera question de composant électrique inséré sur le socle, il faudra donc généraliser au cas où le composant électrique est lui-même constitué par une seconde plaque de circuit imprimé. De la même façon, chaque fois qu'il sera question de pattes du composant électrique, il faudra comprendre que dans le cas où ledit composant est constitué par un circuit imprimé, on entend également par pattes les pistes de ce circuit imprimé.

Ces buts sont atteints selon l'invention au moyen d'un socle permettant de fixer de manière amovible un deuxième composant électrique, par exemple un circuit intégré, comportant une pluralité de pattes de connexion sur un premier composant électrique, par exemple une plaque de circuit imprimé, comportant un support maintenu entre les deux composants électriques et muni d'une pluralité d'ouvertures traversantes disposées de la même manière que lesdites pattes de connexion, une pluralité de broches s'étendant de manière sensiblement perpendiculaire au support. Une extrémité de chaque broche est destinée à être mise en contact électrique avec au moins un élément de connexion du premier composant électrique tandis que l'autre extrémité est destinée à être mise en contact électrique avec un élément de connexion du deuxième composant électrique monté. Une broche est disposée dans chacune desdites ouvertures traversantes et maintenue longitudinalement seulement de manière lâche à l'intérieur desdites ouvertures traversantes. Un interstice est ménagé entre une extrémité de chaque broche et l'élément de connexion correspondant du premier composant électrique, et/ou entre l'autre extrémité de chaque broche et l'élément de connexion correspondante du deuxième composant électrique monté. Un élément compressible électriquement conducteur est logé dans au moins un dudit ou desdits interstices, de manière à permettre un contact électrique entre chaque broche et l'élément de connexion correspondant du premier composant électrique et/ou l'élément de connexion correspondant du deuxième composant électrique monté.

Aucuns moyens particuliers ne sont prévus pour maintenir longitudinalement les broches insérées dans les ouvertures de manière très fixe, en sorte que l'épaisseur du socle peut être minimisée. Les broches sont maintenues dans les trous soit par des butées limitant le déplacement sans l'empêcher totalement, soit par frottement sur les surfaces latérales par exemple. Dans le cas où un élément compressible électriquement conducteur, par exemple un ressort spiral, est prévu de chaque côté de chaque broche, la force de chaque ressort peut être équilibrée par déplacement longitudinal de la broche dans l'ouverture, garantissant ainsi une pression des ressorts homogène sur les éléments de connexion des deux composants électriques et donc un contact électrique amélioré.

Les broches peuvent être constituées par un élément allongé sous forme de tige et de préférence en une seule pièce. Dans une variante, les broches sont constituées par un ressort spiral lui-même compressible.

Comme déjà indiqué, l'invention est particulièrement adaptée pour un socle destiné à loger un circuit intégré, mais peut aussi convenir pour des socles aptes à recevoir n'importe quel type de composant électrique ayant une disposition des pattes similaires. L'invention est en outre parfaitement adaptée à des constructions de type "flip-chip" ou à l'interconnexion entre deux plaques de circuit imprimé.

Le brevet US 4,508,405 décrit un socle comportant une pluralité d'ouvertures traversantes. Une broche fixe est forcée dans chaque ouverture traversante tandis qu'une seconde broche mobile peut coulisser longitudinalement dans l'ouverture, les deux broches étant séparées par un interstice dans lequel est logé un ressort. Deux broches doivent être usinées par ouverture. Une des broches est forcée, impliquant que le support de socle doit être suffisamment épais pour résister aux déformations. Les composants amovibles fixés sont directement en contact avec les broches, ce qui ne garantit pas un contact électrique optimal avec toutes les formes de pattes de connexion.

Le document japonais déposé le 20 janvier 1995 et publié le 9 août 1996, montre un alvéole destiné à faciliter le remplacement ou l'enlèvement et la fixation d'un composant à intégration à haute densité LSI. Un socle à intercaler entre une grille de boules BGA et un support quand la matrice de portes binaires (BGA), qui est une variété de LSI, est montée sur le support, est constitué par un corps formé par une plaque isolante; un trou traversant dans cette plaque, un ressort hélicoïdal conducteur logé concentriquement dans ce trou traversant et une boule de soudure située sur une extrémité placée face à la base du ressort hélicoïdal. L'autre extrémité du ressort hélicoïdal, située du côté où est montée la grille de boules BGA, dépasse légèrement de la plaque à l'état normal. La boule de soudure est soudée au réseau de bornes du support et une attache est fixée à la plaque pour immobiliser la grille de boules BGA. Comme l'autre extrémité du ressort hélicoïdal est comprimée par la broche conductrice de la BGA, le ressort hélicoïdal établit un contact élastique avec la broche conductrice.

Le document DE3832410 décrit un dispositif de contact pour un appareil destiné à l'essai de circuits électriques ou électroniques, et par exemple de circuits imprimés, de circuits intégrés ou similaires, du genre comprenant une pluralité d'éléments de contact métalliques qui comportent chacun une tige droite coulissante dont l'extrémité avant sert à venir en contact avec les circuits à essayer, un ressort de compression hélicoïdal étant monté sur cette tige de manière coaxiale pour la pousser sur les circuits à essayer avec lesquels elle doit venir en contact, cependant que la zone terminale avant de ce ressort est en prise avec un endroit de la tige et que son extrémité arrière repose sur un contre-contact métallique qui est monté sur une plaque d'appui, caractérisé par le fait que le ressort de compression hélicoïdal (15) fait saillie vers l'arrière au-delà de la tige (12), et par le fait que la surface de contre-contact est la surface frontale d'un petit-contact métallique séparé (20) qui est monté fixe sur la plaque d'appui (19).

Les buts de l'invention sont en outre atteints au moyen de plaquettes de contact pouvant être montées à l'extrémité des éléments compressibles électriquement conducteurs. Ces plaquettes peuvent être utilisées soit avec des socles à broches fixes, soit avec des socles à broches mobiles.

La présente invention sera mieux comprise à l'aide des variantes de réalisations décrites ci-après à titre d'exemple et illustrées par les figures qui montrent:

La figure 1 une vue latérale d'une première variante de socle sur lequel le circuit intégré est maintenu au moyen de quatre vis latérales.

La figure 2 une vue de dessus de la première variante de socle.

La figure 3 un agrandissement d'une portion du socle désignée par III sur la figure 1.

La figure 4 un agrandissement d'une portion du socle désignée par IV sur la figure III et correspondant à une seule broche à travers un socle décrit dans une autre demande.

Les figures 5 à 14 des agrandissements de la même portion du socle selon diverses variantes de l'invention.

La figure 15 un agrandissement de la même portion du socle dans une variante adaptée aux circuits de type Ball Grid Array, dans laquelle le centrage du circuit intégré est assuré par des moyens autres que les ouvertures traversantes dans le socle.

La figure 16 un agrandissement de la même portion du socle dans une variante adaptée aux circuits de type Column Grid Array.

La figure 17 un agrandissement de la même portion du socle dans une variante adaptée aux circuits de type Land Grid Array.

La figure 18 un agrandissement de la portion du socle correspondant à celle représentée sur la figure 3, dans une variante de l'invention utilisant une natte élastique.

La figure 19 un agrandissement d'une portion du socle désignée par XIX sur la figure 18 et correspondant à une seule broche à travers le socle dans une variante comportant une natte élastique utilisée comme élément compressible.

La figure 20 une vue de dessus d'un socle selon la présente invention dans lequel les moyens d'appui du composant électrique sont constitués par un ressort.

La figure 21 un agrandissement d'une portion d'un socle selon la présente invention dans lequel les moyens d'appui du composant électrique sont constitués par des plaques de maintien et des vis.

La figure 22 un agrandissement d'une portion d'un socle selon la présente invention dans lequel les moyens d'appui du composant électrique sont constitués par un cadre de maintien.

La figure 23 une vue de dessus d'un socle selon la présente invention dans lequel les moyens d'appui du composant électrique sont constitués par un radiateur vissé au-dessus du circuit intégré.

La figure 24 une coupe à travers une portion d'un socle selon la variante de la figure 23.

La figure 25 une vue latérale d'une portion d'un socle sur lequel le composant électrique est maintenu par un ressort clip.

La figure 26 une vue de dessus d'un socle selon la variante de la figure 25.

La figure 27 une vue latérale d'un socle selon la présente invention sur lequel le composant électrique est maintenu par un dispositif à baillonnette auto-bloquant (cam-lock).

La figure 28 une vue partielle et de dessus d'un socle selon la figure 27.

La figure 29 une coupe à travers une portion de socle avec une seule broche, la broche étant maintenue à l'intérieur de l'ouverture par deux plaques coulissantes.

La figure 30 une coupe à travers une portion de socle avec une seule broche, la broche étant du type ressort spiral et maintenue à l'intérieur de l'ouverture par deux plaques coulissantes.

La figure 31 une coupe à travers une portion de socle avec une seule broche, la broche étant soudée sur le circuit imprimé et maintenue à l'intérieur de l'ouverture par deux plaques coulissantes, le socle pouvant être retiré en écartant les plaques coulissantes pour vérifier l'état des soudures.

La figure 32 une section à travers un goujon permettant de centrer et de positionner mutuellement plusieurs plaques constituant le support du socle, le goujon traversant le circuit imprimé.

La figure 33 une section à travers un goujon permettant de centrer et de positionner mutuellement plusieurs plaques constituant le support du socle, le goujon étant soudé sur le circuit imprimé.

La figure 34 une coupe à travers une portion de socle illustrant en particulier un premier moyen de retenue d'une plaquette de contact.

La figure 35 un détail en éclaté du ressort spiral et de la plaquette de contact fixée selon une variante de moyen de retenue de l'invention.

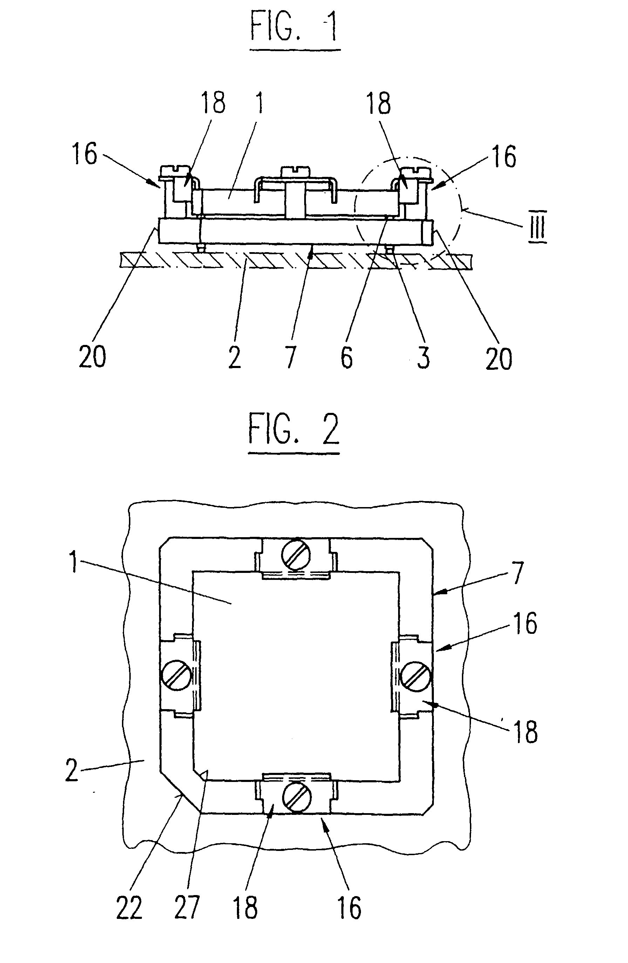

Les figures 1 à 4 illustrent une variante de socle déjà décrite dans la demande WO96/38030, dont le contenu est ici incorporé par référence. Toutes les caractéristiques décrites dans cette demande, mis à part celles concernant la mobilité longitudinale des broches 3, s'appliquent également aux socles selon la présente invention.

Le (deuxième) composant électrique 1, par exemple un circuit intégré, comporte un certain nombre de pattes 6 sur sa face inférieure proche du circuit imprimé 2 (premier composant électrique). Les pattes sont disposées selon une matrice (Grid Array) occupant pratiquement toute la surface inférieure du circuit intégré 1. Selon le composant, la matrice peut aussi se réduire à une ou plusieurs matrices. Dans l'exemple représenté, les pattes 6 présentent la forme d'une portion de sphère, plus particulièrement d'une demi-sphère. Cette disposition et cette forme des pattes sont connues sous la dénomination anglo-saxonne de Ball Grid Array (BGA). Comme nous le verrons plus loin, l'invention s'applique aussi à des socles destinés à loger des circuits d'autre type, par exemple de type Column Grid Array (CGA), Land Grid Array (LGA), flip-chip ou à des liaisons carte-à-carte.

Il n'est naturellement pas indispensable que les pattes soient réparties sur toute la surface inférieure du circuit intégré; des variantes peuvent facilement être imaginées par l'homme du métier pour des circuits dont la face inférieure comporte une ou plusieurs régions dépourvues de pattes, ou pour une disposition des pattes sur deux colonnes, selon un motif en croix, etc..

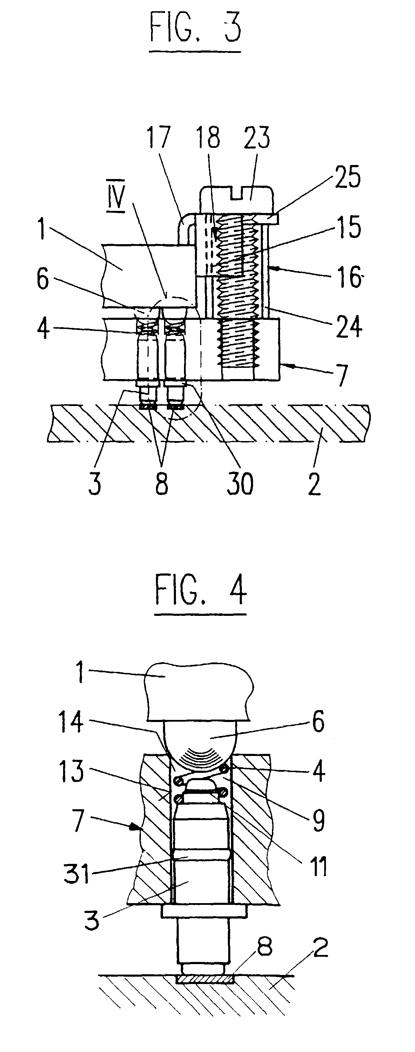

Le socle comporte un support 7 au moins partiellement plat maintenu entre le circuit imprimé 2 et le composant électrique 1. Ce support est par exemple composé par une plaque d'epoxy ou de matériau thermoplastique, et peut être obtenu soit par des opérations de découpage et d'usinage à partir d'une plaque, soit par moulage. Il est traversé par une pluralité d'ouvertures 13 disposées sous forme de matrice correspondant à la matrice de répartition des pattes 6 du circuit intégré 1. Une broche 3 électriquement conductrice est disposée à l'intérieur de chaque ouverture 13. Sur les figures 3 et 4, ces broches traversent le support 7 et dépassent sous la surface inférieure du socle. L'extrémité inférieure de ces broches est sensiblement plate, de manière à pouvoir être soudée sur les pistes 8 d'un circuit imprimé 2. Ce type de montage est généralement connu sous le nom de montage de pièces en surface (SMD: Surface Mounted Device). Une butée 30 limite la profondeur de pénétration des broches 3 à l'intérieur des ouvertures 13. Dans le cas de broches soudées, cette butée 30 empêche en outre que la soudure ne remonte par capillarité dans les ouvertures 13 et ne bloque les broches 3.

Le circuit 1 est posé par-dessus le support plat 7 de manière à ce que ses pattes pénètrent légèrement à l'intérieur des ouvertures correspondantes 13. Les surfaces latérales de l'extrémité supérieure 14 des ouvertures 13 permettent de guider et de positionner avec précision le circuit intégré 1 au-dessus du socle. Nous verrons plus loin que le circuit intégré 1, en particulier s'il est de type LGA, peut aussi être centré avec d'autres moyens, par exemple avec un cadre de centrage. Un interstice 9 est ménagé entre l'extrémité supérieure des broches 3 et la patte de connexion 6 correspondante du composant électrique monté. Chaque interstice est court-circuité par un ressort spiral métallique 4, électriquement conducteur, de manière à permettre un contact électrique entre chaque broche 3 et la patte de connexion 6 correspondante du composant électrique monté. L'extrémité supérieure de chaque broche est aménagée de manière à retenir le ressort dans l'ouverture 13 même lorsque le circuit 1 est retiré du socle. La spire inférieure du ressort est insérée autour de la tête de broche 11, la force de maintien élastique du ressort autour de la tête étant suffisante pour que le ressort reste lié à la broche même lorsque le socle est retourné ou secoué par exemple. Cette configuration présente l'avantage de ne pas nécessiter de soudure coûteuse entre le ressort 4 et la broche, et permet de réaliser un ressort et une broche dans des matériaux différents adaptés à leurs cahiers des charges respectifs.

Les ressorts 4 sont légèrement comprimés lorsque le circuit intégré est en place et garantissent ainsi un contact électrique de très bonne qualité, même lorsque les pattes 6 et/ou les broches 3 présentent des longueurs légèrement différentes en raison d'irrégularités de fabrication ou d'usure. La force nécessaire pour insérer le circuit intégré 1 sur le socle correspond seulement à la force nécessaire pour comprimer les ressorts 4. Comme il n'y a pas de frottement axial entre les pattes 6 et les surfaces latérales des ouvertures 13, cette force est très limitée, excluant ainsi tout risque de pliage ou de cassure de pattes. La longueur des ressorts 4 est de préférence choisie telle qu'ils ne dépassent pas (ou très peu, de moins de 0,2 millimètres) au-dessus des ouvertures 13, même lorsque le composant 1 n'est pas monté. De cette manière, les pattes 6 du circuit intégré 1 sont parfaitement dirigées par les surfaces latérales de l'extrémité supérieure de l'ouverture 13 dès le début de l'insertion du circuit 1 sur le socle. En outre, cette configuration permet de centrer parfaitement l'extrémité du ressort 4 face à la patte 6, ce qui ne serait pas le cas si les ressorts dépassaient librement au-dessus des ouvertures 13. Le diamètre des ressorts est constant sur toute leur longueur, ou au moins symétrique par rapport au milieu du ressort, ce qui permet de les assembler par vibration sans contrôler quelle extrémité du ressort pénètre la première dans l'ouverture. Le nombre de spires du ressort est limité, de préférence compris entre 2 et 5, afin de réduire l'inductance résultante du contact et de permettre d'utiliser le socle pour connecter des circuits intégrés fonctionnant à haute fréquence.

Des moyens d'appui 16 du circuit intégré contre les broches sont prévus afin de garantir un contact parfait et homogène entre toutes les pattes 6 du circuit 1 et les broches 3 correspondantes. Sur les figures 1 à 3, ces moyens d'appui 16 sont constitués par quatre éléments d'appui 18, chaque élément 18 appuyant sensiblement sur le milieu d'une des faces du circuit 1. Chaque élément 18 est traversé par une vis de maintien 23 engagée dans une ouverture du support 7 prévue à cet effet. La vis de maintien 23 traverse en outre une colonnette 24 dont l'extrémité inférieure vient en appui contre le support 7 tandis qu'une plaquette 25 est insérée entre son extrémité supérieure et la tête de la vis 23. La plaquette 25 comporte un coude 17 qui s'étend par-dessus la face supérieure du circuit 1. Lorsque la vis est suffisamment engagée dans le support 7, l'extrémité du coude 17 vient s'appuyer contre la face supérieure du circuit 1 qui est de cette façon pressé contre le support 7. Un réglage adapté des quatre vis 23 permet d'exercer une pression égale sur le milieu de chacun des côtés du circuit intégré 1, et ainsi de garantir un contact homogène entre toutes les pattes 6 et les broches associées 3.

Un marquage 22, constitué sur la figure 2 par un angle coupé du support 7, correspond à un marquage équivalent 27 sur le circuit 1 et permet d'orienter le circuit 1 lorsqu'il est placé sur le socle.

Dans la demande de brevet WO96/38030 mentionnée ci-dessus, les broches 3 sont fixées à l'intérieur des ouvertures 13 de manière à exclure toute possibilité de déplacement longitudinal. Des butées 30 et des nervures 31 sont prévues expressément à cet effet. La figure 4 illustre une broche 3 munie d'une telle nervure selon l'enseignement de ce document ; les autres caractéristiques illustrées et décrites en relation avec cette figure font toutes parties de la présente invention. Une telle fixation rigide empêchant tout déplacement n'est cependant pas toujours souhaitable. Lorsque la longueur des broches 3 n'est pas rigoureusement uniforme, suite par exemple aux tolérances d'usinage, il peut être préférable d'avoir des broches aptes à se déplacer légèrement à l'intérieur des ouvertures, de manière à répartir les erreurs éventuelles entre l'extrémité inférieure et l'extrémité supérieure de la broche. En outre, les nervures 31 sur chaque broche 3 provoquent des tensions dans le support de socle 7, et éventuellement même des déformations ou des cintrages. Il est donc nécessaire de renforcer le support de socle 7 en lui donnant une certaine épaisseur, ce qui va à l'encontre du but de l'invention qui est de minimiser l'épaisseur. Des opérations d'usinage spécifiques doivent en outre être prévues pour fabriquer ces nervures 31 et ces butées 30.

Selon la présente invention, les broches 3 ne sont pas bloquées longitudinalement à l'intérieur des ouvertures 13, mais seulement maintenues de manière lâche et molle à l'intérieur des ouvertures, de manière à pouvoir éventuellement se déplacer légèrement. Même si les broches ne peuvent pas véritablement se déplacer facilement en raison du frottement contre les parois des ouvertures 13, du moins rien n'est prévu expressément pour les bloquer longitudinalement. Par ailleurs, il est entendu que les broches 3 ne sont mobiles que tant que le socle n'est pas fixé sur le circuit imprimé et qu'aucun circuit intégré n'est inséré sur le socle.

Selon une caractéristique préférentielle importante de l'invention, le diamètre des broches 3 est proche du diamètre des ouvertures 13, et le jeu entre les broches et les ouvertures est de préférence inférieur ou égal à 0,1 millimètre. Les broches sont maintenues ainsi par frottement contre les parois latérales des ouvertures 13, avec une force de maintien au moins égale au poids des broches, afin de pouvoir retourner le socle sans que les broches ne tombent des trous (en particulier dans les variantes sans butée 30). Toutefois, par opposition à la demande préalable susmentionnée, le jeu entre les broches et les ouvertures est suffisamment important pour permettre un certain déplacement longitudinal des broches. Ce jeu très faible entre les broches 3 et les ouvertures 13 permet en outre d'éviter les infiltrations de soudure liquide par capillarité dans les ouvertures.

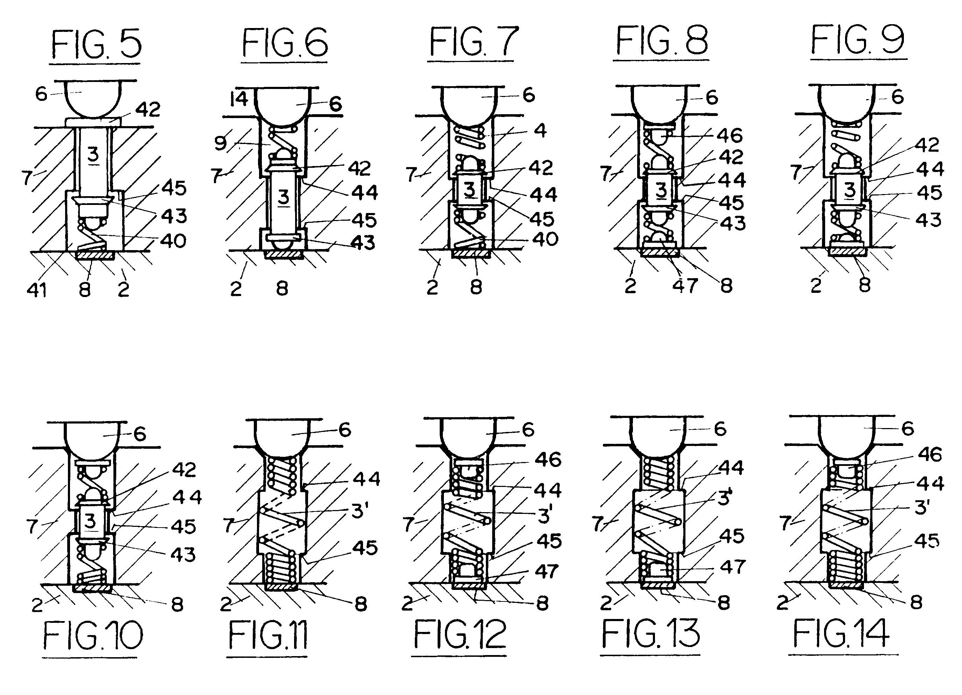

Les figures 5 à 14 illustrent différents exemples de broches 3 maintenues de manière lâche à l'intérieur d'ouvertures 13, correspondant à différentes variantes de la présente invention pouvant être facilement adaptées à un socle tel que celui décrit dans les figures 1 à 3.

Sur la variante de la figure 5, la patte 6 du circuit intégré 1 est en contact direct avec la broche 3 correspondante, aucun interstice 9 ni aucun élément compressible 4 n'étant prévu entre la patte 6 et l'extrémité supérieure de la broche. Un interstice 41 est toutefois ménagé entre l'extrémité inférieure de la broche 3 et la piste correspondante 8 du circuit imprimé 2. L'interstice 41 est court-circuité par un ressort 40 qui établit un contact électrique entre la broche 3 et la piste 8 sur le circuit imprimé 2.

La broche 3 n'est pas fixée longitudinalement dans l'ouverture 13, mais est au contraire apte à se déplacer légèrement. L'ampleur du déplacement est limitée par deux saillies 42, respectivement 43, ménagées à l'extrémité supérieure, respectivement inférieure, de la broche 3 et par un décrochement 45 ménagé dans l'ouverture 13. Lorsque le socle est monté sur le circuit imprimé 2 mais qu'aucun circuit intégré n'est installé dans le socle, le ressort 40 fait ressortir la broche 3 hors de l'ouverture 13, la saillie 43 étant dans ce cas appuyée contre le décrochement 45. Lorsque le circuit intégré 1 est inséré et appuyé contre le socle 7 par des moyens d'appui non représentés, par exemple du type de ceux illustrés sur les figures 1 à 3, la broche 3 redescend en comprimant le ressort, de préférence jusqu'à ce que la saillie 42 ménagée sur la broche vienne en appui contre la surface supérieure du socle 7. Le ressort 40 exerce une pression suffisante sur la broche 3 pour garantir un contact de bonne qualité entre la broche 3 et la patte 6 correspondante, même si les pattes 6 n'ont pas toutes rigoureusement la même longueur ou si l'épaisseur du socle 7 n'est pas rigoureusement constante.

Sur la variante de la figure 6, la broche 3 est en contact direct avec la piste 8 du circuit imprimé 2. Aucun interstice 41 ni aucun élément compressible 40 n'est prévu entre l'extrémité inférieure de la broche et le circuit imprimé. Par contre, de la même manière que dans la variante de la figure 4 déjà décrite dans la demande de brevet mentionnée ci-dessus, un interstice 9 est ménagé entre l'extrémité supérieure de la broche 3 et la patte correspondante 6 du circuit intégré, cet interstice étant court-circuité par un élément compressible électriquement conducteur, ici par un ressort spiral métallique 4. Les surfaces latérales de l'extrémité supérieure 14 de l'ouverture 13 servent de guidage permettant de centrer avec précision le circuit 1 au-dessus du socle, de la façon indiquée ci-dessus.

La broche 3 n'est pas fixe à l'intérieur de l'ouverture 13, mais peut se déplacer légèrement. Une saillie supérieure 42, respectivement une saillie inférieure 43 collaborent avec une butée supérieure 44, respectivement avec une butée inférieure 45, pour limiter l'ampleur du déplacement possible de la broche 3 à l'intérieur de l'ouverture et éviter par exemple que la broche ne puisse sortir de l'ouverture. Nous verrons ci-dessous d'autres moyens possibles pour limiter le déplacement possible des broches 3. Avant que le circuit intégré 1 ne soit inséré dans le socle, la broche 3 flotte donc plus ou moins librement dans l'ouverture 13. Lorsque le circuit intégré est inséré 1 dans le socle et appuyé contre le support 7 par des moyens d'appui quelconques non représentés sur cette figure, la broche 3 vient s'appuyer directement contre la piste 8 correspondante. La pression d'appui est donnée par le ressort 4 qui est compressé avec une force suffisante pour garantir un contact de bonne qualité entre la broche 3 et la piste 8 correspondante, et entre la broche 3 et la patte 6. Même lorsque les broches 3 ou les ouvertures 13 n'ont pas toutes rigoureusement la même longueur, un contact électrique de très bonne qualité peut de cette manière être effectué entre toutes les broches et les pattes et les pistes correspondantes.

Dans une variante de l'invention, les broches 3 peuvent aussi être soudées aux pistes 8 correspondantes du circuit imprimé 2. Dans ce cas, les broches 3 ne sont naturellement mobiles que tant que le socle n'est pas monté sur le circuit imprimé 2. Il est important de veiller dans ce cas à prévoir des éléments de butée 30 et/ou un jeu très faible entre les broches et les ouvertures pour empêcher les infiltrations de soudure lors du soudage.

Sur la variante de la figure 7, un interstice 9 est ménagé entre l'extrémité supérieure de la broche 3 et la patte de connexion 6 correspondante. De la même façon, un interstice 41 est ménagé entre l'extrémité inférieure de la broche 3 et la piste correspondante 8 du circuit imprimé 2. Comme ci-dessus, l'interstice 9 est court-circuité par un ressort spiral métallique électriquement conducteur 4, de manière à permettre un contact électrique entre la broche 3 et la patte de connexion 6 correspondante du composant électrique monté. L'interstice 41 est court-circuité par un ressort 40 qui établit un contact électrique entre la broche 3 et la piste 8 sur le circuit imprimé 2. Sur la figure 7, les ressorts 4 et 40 sont représentés avec des diamètres et des longueurs identiques. On peut cependant préférer avoir des ressorts de diamètre et/ou de longueur différente.

A nouveau, la broche 3 n'est pas totalement fixe à l'intérieur de l'ouverture 13, mais peut se déplacer légèrement, l'amplitude du déplacement possible étant limitée par des butées 44, respectivement 45, collaborant avec des saillies 42, respectivement 43.

Un contact électrique optimal peut être difficile à obtenir avec des ressorts spiraux de type 4 ou 40. En particulier, le contact risque d'être de moindre qualité si le ressort 4 présente une dernière spire du côté de la patte 6 du circuit intégré très inclinée au lieu d'être sensiblement horizontale. Dans ce cas, le contact risque de ne s'établir qu'entre une portion réduite de la dernière spire et la broche 6. L'extrémité du ressort 4 peut en outre s'abîmer en cas d'insertion et d'extraction répétée de circuit intégré dans le socle. Le problème se pose de façon similaire pour le contact entre le ressort 40 et la piste 8, et est particulièrement crucial en cas de contact entre un ressort et la patte d'un circuit LGA.

La variante illustrée par la figure 8 permet de résoudre ce problème au moyen de plaquettes de contact 46 et 47. La plaquette de contact supérieure 46 comporte une surface supérieure sensiblement plane ou concave adaptée de manière à garantir un contact optimal avec la patte 6. La surface inférieure de la plaquette 46 comporte de préférence un ergot (non référencé) inséré à l'intérieur du ressort spiral 4, de manière à garantir également un contact électrique suffisant et un maintien de la plaquette dans le ressort. La plaquette peut aussi être soudée ou liée solidairement de n'importe quelle manière au ressort 4, 40. La plaquette de contact inférieure 47 peut être du même type que la plaquette 46 ou être conçue spécialement pour faciliter le contact et le soudage avec la surface plane de la piste 8 du circuit intégré 2.

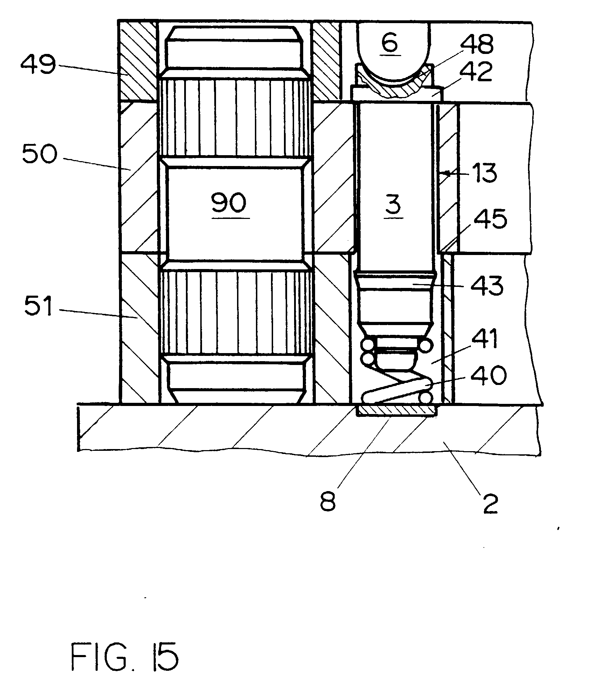

Il est naturellement aussi possible selon les besoins de n'utiliser qu'une plaquette de contact inférieure 47, comme illustré sur la figure 9, ou qu'une plaquette de contact supérieure 46, comme illustré sur la figure 10. L'homme du métier verra immédiatement que des plaquettes de contact inférieures 47 peuvent aussi être utilisées avec la variante de l'invention illustrée par la figure 5, et que des plaquettes de contact supérieures 46 peuvent aussi être utilisées avec la variante de l'invention illustrée par la figure 6. En outre, des telles plaquettes de contact peuvent également être utilisées pour des socles avec broches fixes tels que décrits dans la demande susmentionnée.

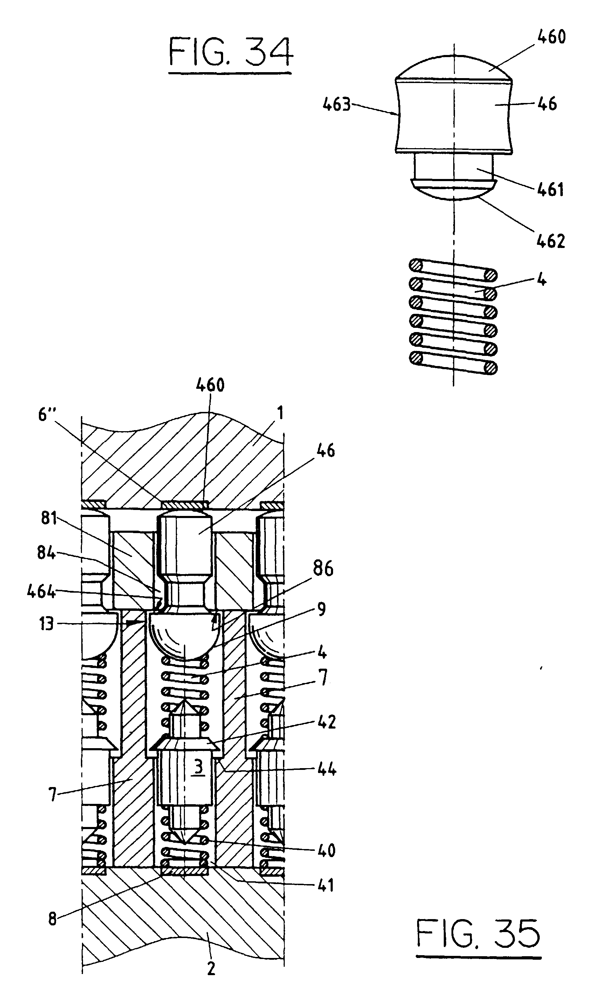

Les plaquettes de contact 46 et 47 seront décrites plus loin plus en détail en relation avec les figures 34 et 35.

Dans les variantes précédentes, les broches en métal 3 peuvent être enfilées par exemple en les forçant dans le support 7 réalisé par exemple en plastique. Nous verrons plus loin que le socle 7 peut aussi être constitué de plusieurs plaques superposées aptes à coulisser les unes par rapport aux autres. Dans ce cas, il est possible d'enfiler les broches 3 dans le support 7 en démontant le socle 7 en faisant coulisser les plaques de la manière appropriée.

Les figures 11 à 14 illustrent quatre variantes de l'invention dans lesquelles la broche de contact 3 est constituée par un ressort spiral 3'. Hormis cet aspect, la variante de la figure 11 correspond à la variante de la figure 7. La broche 3' est constituée par un ressort spiral de diamètre différent de celui des ressorts 4, 40 effectuant le contact électrique avec la patte 6, respectivement avec la piste 8 du circuit imprimé. L'ouverture traversante 13 à travers le socle présente une gorge annulaire peu profonde définissant deux butées 44 et 45. Le ressort spiral 3' peut être inséré par déformation dans cette gorge qui limite ensuite son déplacement longitudinal. A nouveau, le ressort 3' peut également être inséré en démontant le socle 7 ou en faisant coulisser les plaques constituant le socle 7 de la manière appropriée, comme on le verra plus loin. Il est aussi possible de ne pas prévoir de gorge ni de butées 44, 45, le ressort spiral 3' pouvant être maintenu dans l'ouverture 13 par frottement latéral et par sa tendance à l'écartement.

Le ressort spiral 4, la broche 3' et le ressort spiral 40 peuvent être constitués par un seul ressort de diamètre variable le long de sa longueur. Il est aussi possible de réaliser ces trois éléments séparément, de les souder ou de les joindre d'une autre manière, puis de les insérer une fois ainsi rendus solidaires dans l'ouverture 13. Enfin, pour optimiser le contact entre la broche 3' et les ressorts spiraux 4 et 40, particulièrement lorsque ces éléments ne sont pas constitués par un seul élément, on pourrait placer un élément de liaison non représenté assurant une liaison optimale entre ces différents ressorts.

De la même façon que ci-dessus, on constate que la position de la broche 3' n'est pas fixe à l'intérieur de l'ouverture 13, mais qu'au contraire celle-ci peut dans une certaine mesure se déplacer et égaliser la pression de la broche avec la patte 6 et avec la piste 8, même en cas d'inégalités d'épaisseur.

Les figures 12, 13 et 14 illustrent des variantes de la figure 11 dans laquelle des plaquettes de contact 46 et 47 sont prévues pour assurer un meilleur contact avec la patte 6 et/ou avec la piste 8 et pour limiter le risque d'usure ou d'endommagement de l'extrémité des ressorts spiral 4 et 40.

La figure 15 illustre une variante de l'invention dérivée de la variante illustrée par la figure 5. Les éléments identiques ayant la même numérotation, leur description ne sera pas reprise. En comparant ces deux figures, on constate qu'une plaquette 48 est rapportée à l'extrémité supérieure de la broche 3. La forme et/ou le matériau de la plaquette 48 sont choisis de manière à assurer le meilleur contact électrique possible entre la broche 3 et la patte 6 correspondante du circuit intégré 1. La plaquette 48 peut aussi être constituée par un revêtement en or ou en argent de l'extrémité supérieure de la broche 3. La forme concave de la plaquette 48 permet en outre de centrer facilement et avec précision le circuit 1 au-dessus du socle. Sur cet exemple, le circuit est du type BGA (Ball Grid Array); il est évident que la forme de la plaquette 48 sera différente si le circuit est d'un autre type, par exemple CGA (Column Grid Array) ou LGA (Land Grid Array).

Le support 7 du socle est réalisé par deux couches 50, 51 superposées, sur lesquelles est juxtaposé un cadre de centrage 49 permettant de faciliter l'orientation et le centrage du circuit intégré 1. Les couches 50 et 51 ainsi que le cadre de centrage 49 sont reliés par plusieurs chevilles de positionnement 90. Les plaques peuvent être dans les mêmes matériaux ou dans des matériaux différents; nous verrons plus loin une variante dans laquelle les plaques 50 et 51 peuvent coulisser l'une par rapport à l'autre. Grâce aux chevilles de positionnement 90, au nombre de deux au minimum, suffisamment espacées et traversant chaque couche, il est facile d'aligner les couches 49, 50, 51 avec une précision optimale. Le circuit intégré est centré par rapport aux broches 3 soit en appuyant le boîtier du circuit 1 contre le cadre de centrage 49, ou en appuyant les pattes externes 6 du circuit intégré 1 contre le cadre 49. Il est aussi possible de prévoir un cadre de centrage 49 en escalier, la partie inférieure de l'escalier venant en appui contre les pattes externes 6 du circuit tandis que la partie supérieure de l'escalier vient en appui contre le boîtier du circuit 1.

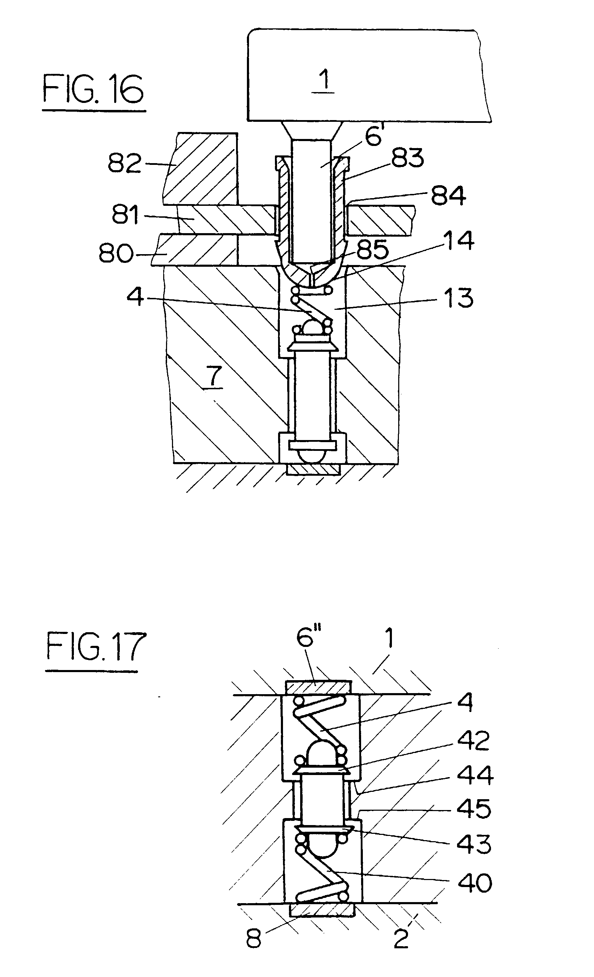

La figure 16 illustre une variante de l'invention plus spécifiquement adaptée à des circuits de type CGA (Column Grid Array). Par rapport aux circuits de type BGA, les circuits de type CGA se distinguent par des pattes 6' réalisées sous formes de petites colonnes, par exemple d'environ 2 mm de hauteur.

La partie inférieure de la figure 16 est tout à fait identique à la partie inférieure de la figure 6 et sa description n'est donc pas reprise ici. Un cadre d'écartement 80 est placé sur le support 7. Un cadre à douilles 81 est à son tour juxtaposé par-dessus le cadre d'écartement 80. Le cadre à douilles 81 est percé par des ouvertures 84 dont le nombre et la disposition correspondent à ceux des pattes 6' du circuit intégré 1 et des broches 3 du socle. Une douille métallique 83 est logée dans chaque ouverture 84. La forme externe de la douille 83 est prévue de manière à pouvoir être forcée dans l'ouverture 84 correspondante et à ne pas pouvoir en ressortir facilement. La forme interne de la douille permet de loger une patte 6' en forme de colonne qui peut y pénétrer facilement et sans forçage. Une ouverture 85 est ménagée dans le fond de la douille 83 qui permet à l'air de sortir lorsque la patte 6' est enfilée. Un cadre de centrage 82 est juxtaposé par-dessus le cadre à douilles 81 et permet de positionner et de centrer aisément le circuit intégré 1 au dessus du socle.

Les douilles 83 fournissent un appui aux pattes 6' pour éviter qu'elles ne se plient, particulièrement lorsqu'elles sont longues ou faites d'un métal plutôt mou. Lorsque toutefois les colonnes 6' sont plus courtes ou risquent moins de se plier, les douilles 6' peuvent être omises. Dans ce cas, des socles similaires aux socles pour circuits BGA peuvent aussi être utilisés avec des circuits CGA, en utilisant le cas échéant des cadres d'écartement supplémentaires ou en adaptant la forme des extrémités supérieures des broches 3 ou des éléments compressibles supérieurs 4. Les douilles 83 constituent en fait des plaquettes de contact spécialement adaptées à des pattes de type CGA.

L'homme du métier comprendra immédiatement que des cadres à douille 81 pour circuits de type CGA, décrits ici uniquement en relation avec la figure 16, peuvent aussi être placés sur n'importe quel socle pour circuit BGA décrit notamment en relation avec les figures 5 à 15 ou 29 à 31, et permettent ainsi d'adapter n'importe lequel de ces socles à des circuits CGA.

La figure 17 illustre une variante de l'invention plus spécifiquement adaptée à des circuits de type LGA (Land Grid Array). Par rapport aux circuits de type BGA ou CGA, les circuits de type LGA se distinguent par des pattes 6" presque plates, réalisées sous formes de petites pastilles directement sous la surface inférieure du circuit intégré 1.

Dans ce cas, la connexion électrique entre la broche 3 et la patte 6" du circuit LGA est effectuée de la même façon que la connexion électrique entre le broche 3 et la piste 8 du circuit imprimé 2. La figure 17 illustre une variante de socle pour circuit LGA correspondant à la variante de socle pour circuit BGA de la figure 7. Par rapport à cette figure, le diamètre et l'inclinaison de l'extrémité du ressort 4 sont adaptés pour garantir un contact électrique optimal avec la surface plate de la patte 6". L'homme du métier comprendra immédiatement que n'importe quel socle pour circuit BGA décrit en relation notamment avec les figures 5 à 15 peut aussi être adapté facilement pour loger des circuits de type LGA, et que des plaquettes de contact 46, 47 peuvent être utilisées à l'extrémité des ressorts 4, 40.

Dans le cas où le socle est utilisé pour des liaisons carte-à-carte entre deux cartes de circuit imprimés, une configuration du socle similaire à celle de la figure 17 sera adoptée, les pattes 6" étant dans ce cas remplacées par les pistes à connecter sur le second circuit imprimé.

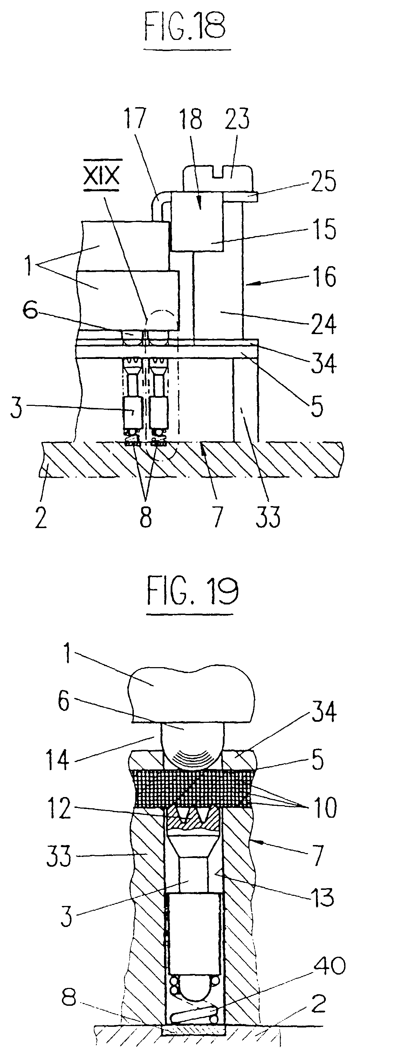

Les figures 18 et 19 illustrent une variante de l'invention dans laquelle l'élément compressible électriquement conducteur inséré dans l'intervalle 9 entre la broche 3 et la patte 6 correspondante du circuit intégré 1 est constitué par une natte 5 élastique. La natte est de préférence constituée de caoutchouc siliconé isolant électriquement et possède de préférence une épaisseur de 0,3 jusqu'à 1 mm environ, voir davantage, ces valeurs étant données ici uniquement à titre d'illustration. Des fils métalliques 10, de préférence des fils dorés, sont intégrés dans la natte. Les fils sont disposés sensiblement perpendiculairement au plan de la natte, à 0.05 jusqu'à 0,1 mm les uns des autres environ, et tous coupés à fleur de la surface supérieure et de la surface inférieure de la natte. Pour réduire le prix de la natte, et selon la taille des pattes 6 et des broches 3, il est possible le cas échéant d'avoir des fils 10 beaucoup plus espacés dans la natte 5. De telles nattes sont commercialisées par la société japonaise SHIN-ETSU par exemple.

Le support de socle 7 est formé de deux plaques superposées 33 et 34 entre lesquelles est disposée la natte compressible 5. Les plaques 33 et 34 ainsi que la natte sont fixées mutuellement par des moyens appropriés non représentés; la natte 5 est suffisamment grande pour s'étendre par-dessus toutes les ouvertures 13. Les broches 3 sont insérées au-dessous de la natte dans les ouvertures 13 à travers la plaque inférieure 33 et peuvent légèrement se déplacer longitudinalement dans ces ouvertures. L'extrémité inférieure des broches 3 est mise en contact électrique avec les pistes 8 correspondantes par l'intermédiaire d'un ressort spiral 40, comme pour la variante illustrée par la figure 5. Des moyens de butée peuvent être prévus pour empêcher que la broche 3 ne puisse sortir par l'extrémité inférieure des ouvertures 13.

L'extrémité supérieure des broches 3 mise en contact avec la natte 5 est conçue pour être mise en contact avec le plus grand nombre possible de fils métalliques 10 dans la natte, et de manière à pouvoir pénétrer légèrement dans la masse élastique de la natte. Sur la figure 19, l'extrémité de la broche 3 est à cet effet munie de plusieurs dents 12 disposées en couronne. D'autres configurations sont aussi possibles, par exemple une extrémité des broches 3 concave présentant une surface de contact circulaire avec la natte 5.

Les pattes 6 du circuit intégré 1 sont insérées dans les ouvertures 13 ménagées dans la plaque supérieure 34, les surfaces latérales de ces ouvertures permettant de guider et de centrer le circuit intégré au-dessus du socle. La plaque supérieure 34 n'ayant pas d'autres fonctions que ce centrage, elle peut être d'épaisseur plus faible que la plaque inférieure 33. Pour des circuits de type LGA, un centrage par les ouvertures 13 n'est pas possible; dans ce cas, d'autres moyens de centrage doivent être prévus, et on peut alors renoncer complètement à la plaque supérieure 34. Le cas échéant, on peut aussi y renoncer pour des circuits BGA, CGA ou flip-chip. Un contact électrique entre chaque patte de contact 6 et la broche correspondante 3 est établi lorsque le circuit 1 est pressé contre le socle grâce aux moyens d'appui déjà évoqués. Au moins un fil, de préférence toutefois une multitude de fils établissent alors un contact électrique fiable à travers la natte 5 comprimée.

Même si, suite par exemple à une utilisation répétée, la natte 5 n'a pas la même épaisseur dans toutes les ouvertures 13, la broche 3 n'est pas fixée fermement à l'intérieur des ouvertures. Un certain jeu permet de cette manière de compenser les irrégularités possibles et d'assurer ainsi une pression suffisante dans chaque ouverture 13 entre la broche 3 et la natte 5.

Pour ne pas alourdir la description, l'utilisation d'une natte 5 comme élément compressible remplaçant le ressort spiral 4 n'a été illustrée et décrite ici que dans une configuration correspondante à celle de la figure 7; l'homme du métier comprendra toutefois qu'il est aussi possible d'utiliser des nattes similaires pour remplacer n'importe quel ressort 4 ou 40 dans n'importe laquelle des configurations décrites en relation avec les figures 5 à 15 ou 29 à 31. En particulier, il est également parfaitement possible de remplacer les ressorts spiraux 4 et 40 dans les variantes des figures 11 à 14 par une natte compressible, en conservant un ressort spiral 3' comme broche entre les deux nattes. A cet effet, il peut être préférable de modifier les deux extrémités du ressort spiral 3', ou de prévoir une pièce d'adaptation à chaque extrémité, pour garantir un excellent contact avec les fils 10 à l'intérieur de la natte.

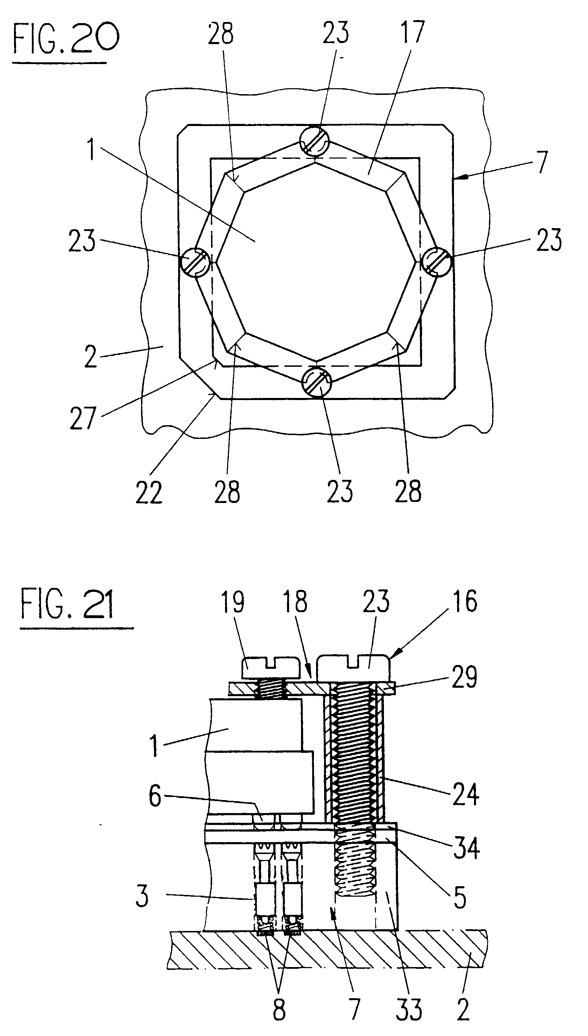

La figure 20 illustre une variante des moyens d'appui du composant électrique 1 contre les broches 6 du socle. Dans cette variante, les moyens d'appui sont constitués par un ressort 17 de forme approximativement polygonale, par exemple rectangulaire ou carrée. A l'état libre, le ressort 17 est constitué par- huit brins inclinés de 45° environ par rapport à l'horizontale, l'inclinaison de deux brins successifs étant à chaque fois opposée. Lorsque le ressort est fixé, les angles supérieurs du ressort sont bloqués chacun sous la tête d'une vis de fixation 23. Le circuit intégré 1 est comprimé en quatre endroits contre le socle 7 par les points d'appui 28. En vissant ou dévissant plus ou moins les vis 23, on peut ajuster la pression exercée par le ressort 17.

Il est évident que d'autres formes de ressort peuvent être choisies. Il est également possible de disposer le ressort différemment, par exemple en sorte qu'il n'appuie pas directement sur le circuit intégré 1, mais seulement par l'intermédiaire d'une pièce supplémentaire ou le cas échéant d'un radiateur de refroidissement.

Une autre variante des moyens d'appui est illustrée par la figure 21. Quatre éléments d'appui 18, dont un seul est représenté ici, sont prévus comme sur la variante de la figure 1. Les vis de fixation 23 permettent d'exercer par l'intermédiaire d'une plaque de maintien 29 une pression sur la face supérieure du circuit intégré 1. L'intensité de la pression peut être ajustée en vissant ou en dévissant plus ou moins les vis 23. Des vis de réglage supplémentaires 19 engagées dans des trous filetés à travers la plaque de maintien 29 permettent d'ajuster la pression contre le dos du circuit 1 en de multiples endroits. On pourrait aussi renoncer aux vis d'ajustage 19 et n'utiliser que les vis de fixation 23 pour régler la pression.

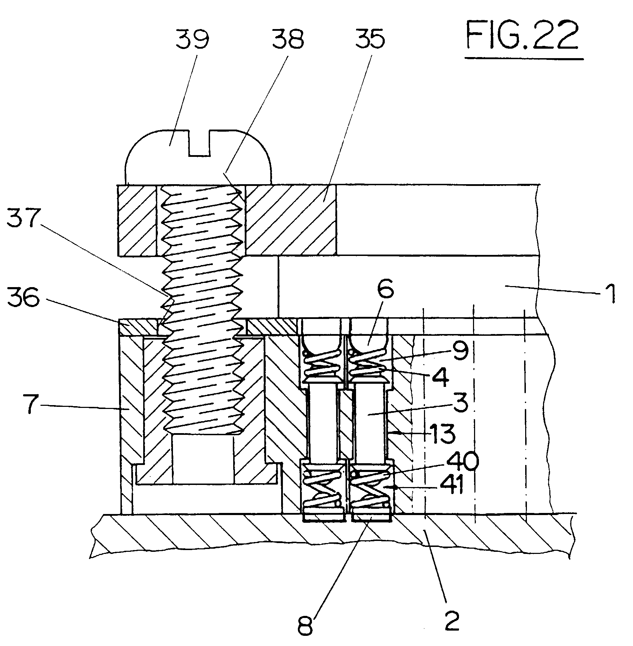

Une plaque ou un cadre de maintien unique peut être prévue au lieu d'éléments de maintien individuels. Sur la figure 22, un cadre 35 sert d'élément de maintien exerçant une pression sur la face supérieure du circuit intégré 1. Ce cadre peut être en métal ou de préférence en matériau synthétique. Un autre cadre 36 au-dessus du support 7 permet de guider latéralement et de centrer parfaitement le circuit intégré 1 au-dessus du socle. Le cadre de centrage 36 est pincé et maintenu entre le support 7 et le circuit intégré 1. Des trous 37 sont prévus dans le cadre de centrage et alignés coaxialement avec des trous correspondants 38 dans le cadre de maintien 35. Des vis de fixation 39 traversent ces trous 37 et 38 et sont engagées dans un filetage prévu dans le support 7. Les cadres 35 et 36 permettent d'une part de faciliter le centrage du circuit intégré 1, d'autre part d'éviter une pression ou une éventuelle déformation du circuit intégré 1 lorsque les vis de fixation sont trop serrées.

Il est également possible d'utiliser une plaque de maintien plutôt qu'un cadre 35. Dans ce cas, il est possible de fixer un radiateur sur la face supérieure de la plaque de maintien, ou de configurer la plaque elle-même comme un élément de radiateur.

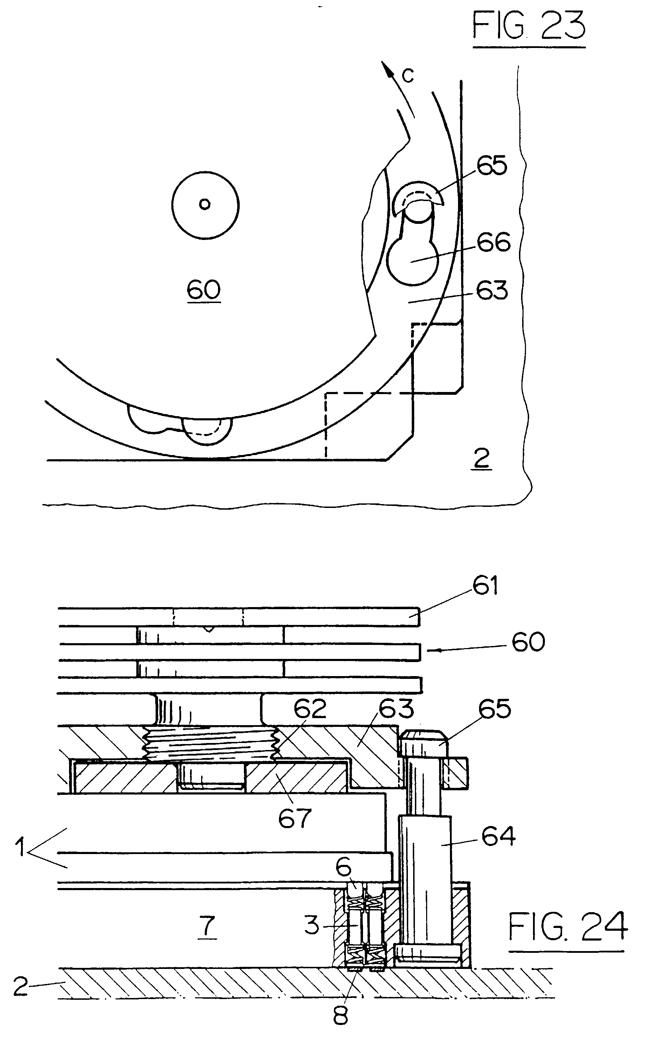

Une autre possibilité de maintenir et d'appuyer le circuit intégré 1 au-dessus du socle est illustrée sur les figures 23 et 24. Une rondelle d'appui 67 est posée directement sur le circuit intégré. Cette rondelle est par exemple en métal et possède une bonne conductibilité thermique. Une plaque supplémentaire 63 est juxtaposée par-dessus la rondelle d'appui 67 et maintenue au-dessus du socle grâce à quatre colonnes 64 traversant des ouvertures 66 dans la plaque supplémentaire. Les colonnes 64 sont liées solidairement au support du socle 7 ou à la carte de circuit imprimé 2. La forme des têtes de colonnes 65 et celle des ouvertures 66 permet de retirer la plaque supplémentaire 63 en la faisant d'abord tourner légèrement dans le sens de la flèche c, jusqu'à ce que les têtes 65 soient en face d'élargissements prévus dans les ouvertures 66, puis en la soulevant. Le montage du circuit intégré 1 se fait de manière inverse en posant successivement le circuit intégré 1 au-dessus du socle, puis la rondelle d'appui 67 sur la face supérieure du circuit 1, puis en enfilant la plaque supplémentaire 63 par dessus les têtes de colonnes et en la faisant pivoter dans le sens opposé à la flèche c. Un cadre de centrage en matériau synthétique, non représenté, peut être prévu autour du circuit intégré 1 pour faciliter son positionnement.

Un radiateur de refroidissement 60 comportant plusieurs ailettes 61 est ensuite vissé à travers une ouverture 62 au centre de la plaque supplémentaire 63. En le vissant, il vient s'appuyer contre la rondelle d'appui 67 qui exerce à son tour une pression sur la face supérieure du circuit intégré 1, maintenant ce dernier fermement appuyé au dessus des broches 3.

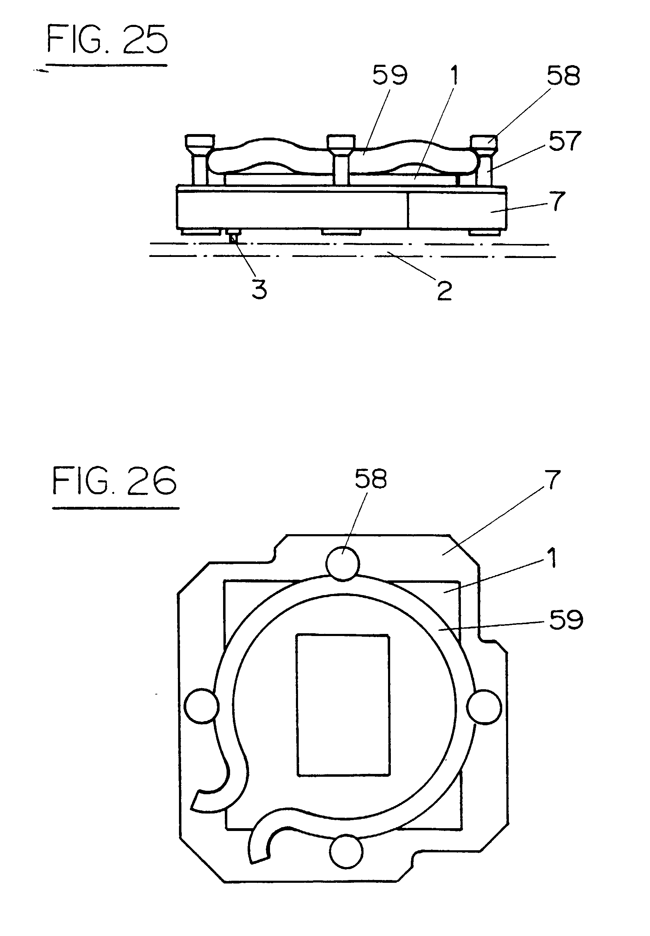

Une autre possibilité de maintenir et d'appuyer le circuit intégré 1 au-dessus du socle est illustrée sur les figures 25 et 26. Le socle 7 est muni de quatre colonnes 57, chaque colonne étant terminée par une tête 58 élargie. Le circuit intégré 1 correctement orienté entre ces quatre colonnes est maintenu par un ressort 59 coincé entre le circuit intégré 1 et les quatre têtes 58 de colonnes 57. Le ressort 59 n'est de préférence pas plan, mais ondulé de manière à comprimer efficacement les différentes de hauteur ou d'épaisseur éventuelles du socle 7, du circuit intégré 1 ou des colonnes 57.

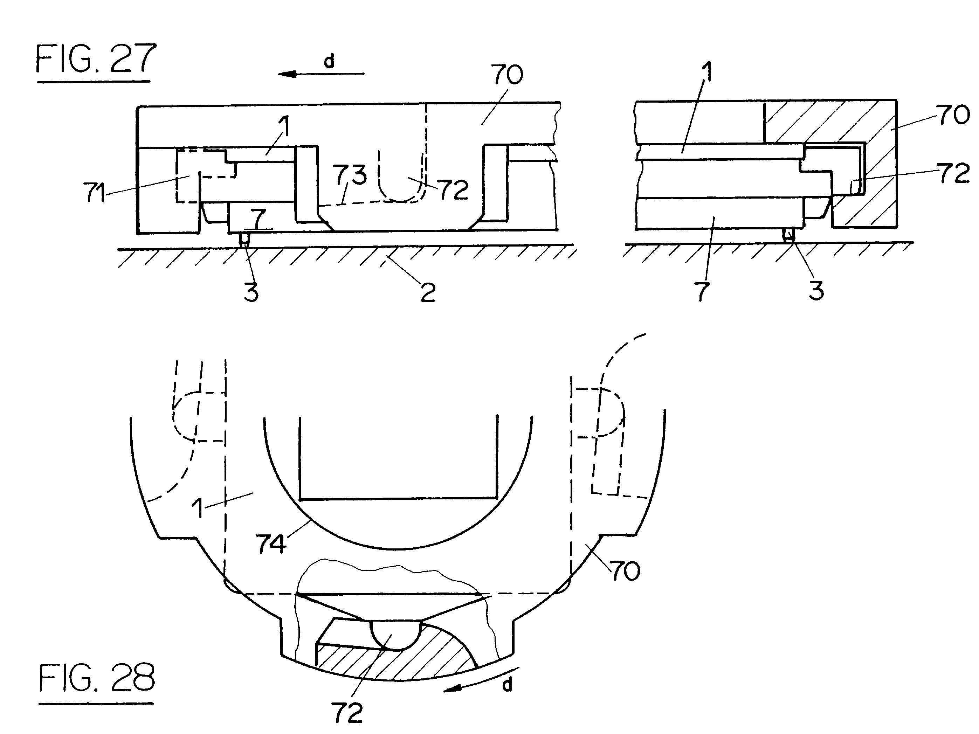

Les figures 27 et 28 illustrent encore une autre possibilité de maintenir et d'appuyer le circuit intégré 1 au-dessus du socle. Une bague de maintien 70 collabore avec une pièce intermédiaire 71 pour bloquer le circuit intégré 1 et l'appuyer contre le support de socle 7. La pièce intermédiaire 71 est insérée sous le circuit intégré 1 et maintenue solidaire du socle par des moyens non représentés; elle comporte une assise proéminente 72 en quatre points. La pièce intermédiaire 71 est réalisée par injection; dans une variante, elle peut aussi être intégrée au support de socle 7. La bague de maintien 70 peut être enfilée par-dessus le circuit 1 et la pièce intermédiaire 71; en la faisant pivoter légèrement dans le sens de la flèche d, une surface d'appui inclinée 73 de la bague 70 vient se mettre en appui contre chaque assise proéminente 72. En faisant pivoter davantage la bague, la pression d'appui augmente tout d'abord avec le niveau de la surface 73, puis se relâche avec un déclic lorsque l'assise proéminente 72 a passé par-dessus le point supérieur de la surface d'appui inclinée 73. Ce type de maintien par bague ou par élément à baillonnette auto-bloquant est connu sous le nom de "cam-lock".

La bague de maintien 70 présente une grande ouverture centrale 74 permettant de voir la surface supérieure du composant électrique 1 et si nécessaire d'y fixer un radiateur ou un élément de refroidissement. D'autres configurations de la bague de maintien peuvent être aisément imaginées afin de faciliter la fixation d'un radiateur; par exemple, la bague de maintien auto-bloquante peut être remplacée par quatre pivots de maintien auto-bloquants permettant de fixer le circuit intégré au socle en quatre endroits tout en laissant accessible la plus grande partie possible de la surface supérieure du circuit intégré.

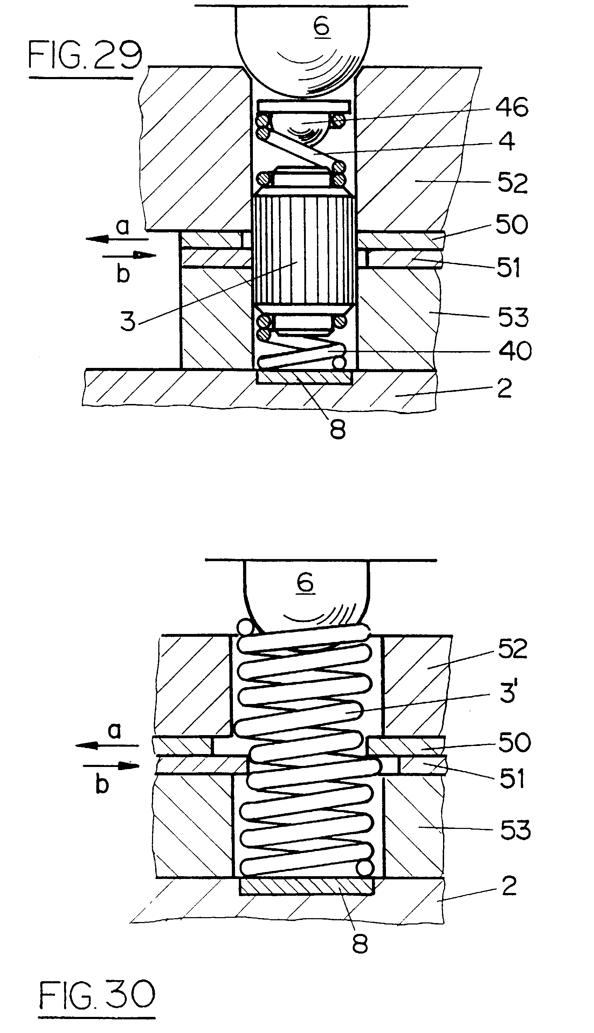

Dans les exemples donnés ci-dessus, des moyens de type butée 44, 45 et saillies 42, 43 sont prévus pour retenir les broches à l'intérieur des ouvertures 13 et empêcher ainsi qu'elles ne puissent sortir lorsque le socle est retourné ou secoué par exemple. Ces moyens rendent la fabrication et le montage du socle plus compliqués, et peuvent en outre nécessiter une épaisseur du socle plus importante. Il est éventuellement possible de ne retenir les broches 3 ou 3' que grâce au frottement contre les parois latérales des ouvertures 13; toutefois, le compromis est difficile à trouver entre un maintien suffisant et une mobilité nécessaire des broches. La figure 29 illustre une variante de l'invention fonctionnant sans butées. Le support de socle 7 est formé dans cette exemple de deux plaques superposées 52 et 53 entre lesquelles sont disposées deux plaques plus fines 50 et 51. Les plaques 52 et 53 sont fixées mutuellement par des moyens appropriés, par exemple par des pinces ou par des vis ou des rivets ne traversant pas les plaques intermédiaires 50 et 51. Des ouvertures traversantes 13 sont ménagées à travers les quatre plaques 50 à 53 aux endroits correspondant aux pattes du circuit intégré. Une broche 3 est insérée dans chaque ouverture. Le contact électrique entre chaque broche 3 et la piste 8 correspondante, respectivement avec la patte correspondante du circuit intégré, est assuré par l'intermédiaire d'éléments compressibles électriquement conducteurs, dans cet exemple par l'intermédiaire de ressorts spiral 4 et 40.

Les plaques intermédiaires 50, 51 peuvent se déplacer dans leur propre plan comme indiqué par les flèches a et b. Des moyens non représentés sont de préférence prévus pour permettre à l'utilisateur de les déplacer facilement; par exemple, les plaques 50 et 51 peuvent s'avérer plus larges selon une direction au moins que les plaques 52 et 53, permettant ainsi à un opérateur de les pousser. En poussant par exemple la plaque 50 dans le sens indiqué par la flèche a et la plaque 51 dans le sens indiqué par la flèche b, on parvient ainsi à prendre en étau et à coincer simultanément toutes les broches 3 dans leur trou 13 respectif. Les plaques 50 et 51 peuvent de préférence être bloquées au moyen de chevilles 90 (figure 15) dans une position permettant un maintien relâché des broches dans les trous et qui autorise un minimum de liberté de déplacement.

En déplaçant à nouveau les plaques 50 et 51 de manière à aligner parfaitement les trous 13 sur les quatre plaques, il est possible de libérer les broches 3 et de les extraire ou d'en remplacer une partie si nécessaire.

La figure 30 illustre une autre variante de l'invention dans laquelle le principe de plaques de serrage et de maintien 50, 51 est utilisé avec des broches 3' de type ressort spiral. Pour la simplification de la figure, la broche 3' et les éléments compressibles électriquement conducteur 4 et 40 sont constitués par un seul ressort spiral de diamètre constant tout au long de sa longueur. Il est cependant évident que le principe de maintien s'applique tout aussi bien si, comme dans les variantes illustrées sur les figures 5 à 14, la broche 3' est constituée d'un ressort différent et éventuellement de diamètre différent que les éléments compressibles 4 et 40. Suivant la position des plaques 50 et 51, il est possible soit de maintenir le ressort fermement dans l'ouverture 13, un certain déplacement longitudinal étant toutefois autorisé par la déformabilité du ressort, soit de libérer complètement le ressort 3' pour pouvoir éventuellement le remplacer.

Il est naturellement aussi possible d'utiliser un nombre de plaques de maintien coulissantes différent de deux, par exemple de n'utiliser qu'une seule plaque coulissante par rapport à une plaque fixe.

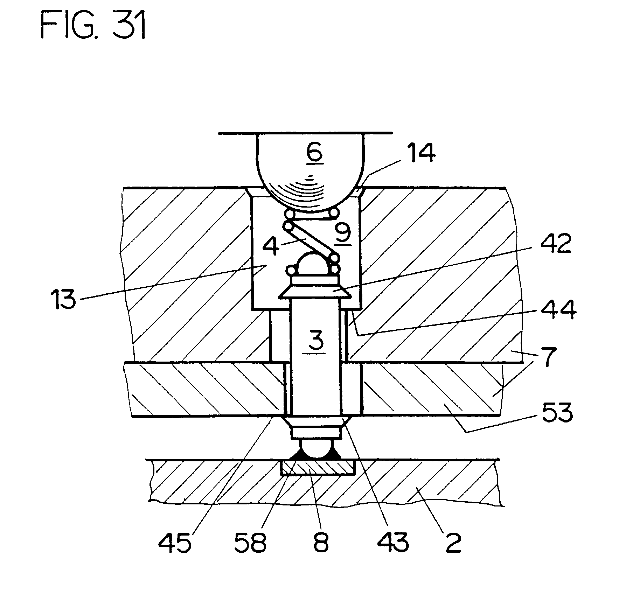

La figure 31 illustre une variante de l'invention dans laquelle les broches 3 sont maintenues dans le support 7 au moyen de butées 44, 45, collaborant avec des saillies 42, respectivement 43. Le support 7 est formé de deux plaques 52, 53 aptes à coulisser l'une par rapport à l'autre. Selon la position mutuelle donnée aux plaques 52 et 53, on peut rapprocher ou éloigner les butées 44 et 45 et donc soit maintenir les broches 3 axialement, soit élargir les ouvertures 13 de manière à ce que les plaques 52 et 53 puissent être soulevées et retirées par-dessus les broches 3. La plaque inférieure 53 n'est pas en contact avec le circuit imprimé 2; elle est au contraire maintenue appuyée par les saillies 43 des broches 3 contre la plaque supérieure 52 en laissant un interstice entre le support 7 et le circuit imprimé 2. Les broches 3 sont par exemple soudées aux pistes 8 en injectant de l'air chaud par cet interstice.

Sur la figure 31, les broches 3 sont soudées sur les pistes 8 du circuit imprimé: en retirant les plaques 52 et 53 après soudage, il est possible de vérifier et le cas échéant de réparer très facilement les soudures 58. Une butée est prévue pour retenir la soudure et l'empêcher de remonter par capillarité dans l'ouverture 13.

Dans une variante non illustrée, les broches 3 pourraient être simplement appuyées contre les pistes 8 du circuit imprimé, sans soudure. Dans ce cas, le socle 7 est maintenu contre le circuit imprimé 2 par exemple au moyen de vis traversant ces deux éléments et permettant d'exercer un appui suffisant entre les broches 3 et les pistes 8 pour garantir un contact électrique de qualité.

Il est naturellement aussi possible de prévoir des socles 7 formés d'un nombre quelconque de plaques coulissantes pouvant être retirées pour vérifier les soudures. En outre, l'homme du métier comprendra que ce type de broches mobiles bloquées par soudage ou appui lors de l'assemblage du socle sur la carte de circuit imprimé peut aussi être utilisé avec les autres variantes de socle discutées.

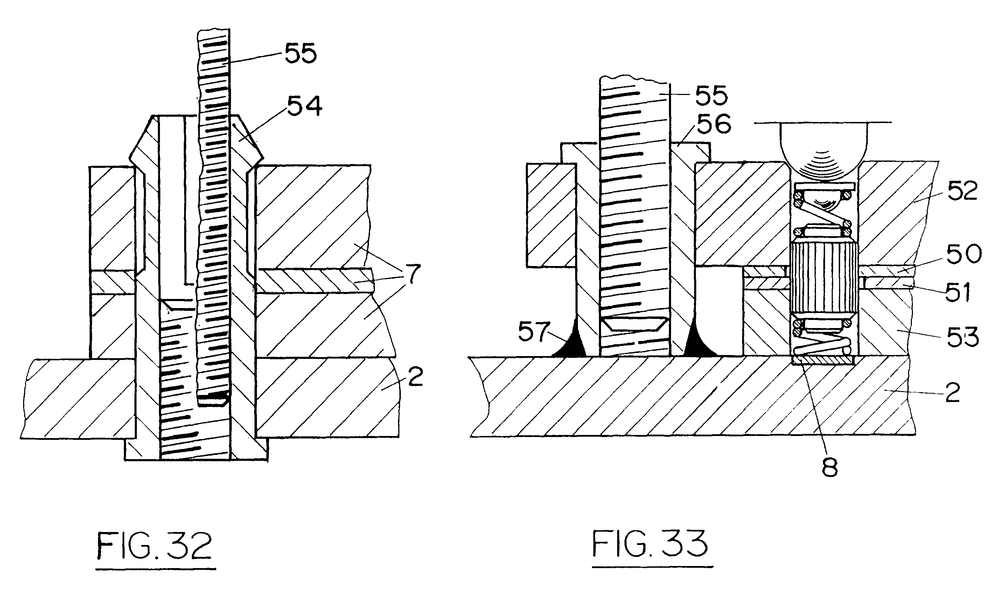

La figure 32 illustre un goujon traversant 54 permettant de fixer et de centrer un socle 7 sur le circuit imprimé 2. Une telle fixation est nécessaire lorsque les broches 3 ou les éléments compressibles 40 ne sont pas soudés aux pistes 8 du circuit imprimé 2; même lorsque les broches sont destinées à être soudées sur le circuit imprimé, des goujons permettent de faciliter le positionnement et le centrage préalablement au soudage. Le goujon 54 est formé de plastique ou de métal et traverse le circuit imprimé 2 ainsi que dans cet exemple toutes les couches du socle 7. Il est inséré par forçage et maintenu par un contre-élément fileté 55 vissé à l'intérieur du goujon.

Dans le cas de cartes de circuit imprimé particulièrement complexes, comprenant par exemple une multitude de couches de pistes, il peut être difficile de prévoir des ouvertures à travers la carte pour le passage des goujons 54. Dans ce cas, on peut aussi utiliser des goujons fixés par soudure directement sur la carte de circuit imprimé, comme illustré sur la figure 33. Dans cette figure, un goujon 56 fixé au circuit imprimé 2 par des soudures 57 maintient uniquement la couche supérieure 52 du circuit imprimé; les autres couches 50, 51 et 53 peuvent coulisser par rapport à cette couche fixe 52, comme expliqué ci-dessus. Un contre-élément fileté 55 vissé à l'intérieur du goujon 56 permet de le maintenir une fois introduit. Les quatre couches 50 à 53 peuvent être fixées mutuellement par une cheville 90 (figure 15) dans une position autorisant un léger déplacement des broches 3.

Pour empêcher tout pivotement du socle par rapport au circuit imprimé 2, on utilisera au moins deux, de préférence toutefois quatre goujons 54 ou 56. De préférence, ces goujons seront disposés aux quatre coins du socle plutôt que sur ses côtés. De cette manière, on conserve un maximum de possibilités de placer des pistes 8 sous le circuit imprimé pour accéder à ses entrées-sorties.

La figure 34 illustre un détail de plaquette de contact 46 pouvant être fixée à l'extrémité du ressort 4 opposée à la broche 3. La plaquette de contact 46 est maintenue dans cet exemple à l'extrémité du ressort 4 par un prolongement 461 de plus faible diamètre introduit entre les spires du ressort 4 et s'élargissant en un collet 462 permettant de retenir la plaquette 46 à l'intérieur du ressort. Le collet 462 permet en outre d'améliorer le contact électrique entre le ressort 4 et la plaquette 46. La plaquette peut aussi être liée au ressort par n'importe quels moyens connus, la solution illustrée offrant toutefois l'avantage de plaquettes amovibles et d'un montage économique sans soudage.

Les flancs latéraux de la plaquette de contact 46 sont verticaux ou de préférence, comme illustré sur cette figure, munis d'une gorge concave 463. Cette gorge permet de faciliter le soudage de la plaquette lorsque celle-ci est soudée plutôt que simplement appuyée contre l'élément de connexion correspondant. Dans ce cas, les surplus éventuels de pâte à souder sont capturés par la gorge et ne risquent ainsi pas de s'écouler jusqu'au ressort 4. La section de la gorge 463 ou de la portion concave des flancs de la plaquette peut être quelconque, par exemple trapézoïdale ou arrondie.

La figure 35 illustre une variante de moyens de retenue des plaquettes de contact 46. Dans ce cas, les plaquettes 46 sont simplement posées sur la surface du ressort 4, l'extrémité de la plaquette proche du ressort ayant une forme adaptée pour assurer un contact électrique optimal avec le ressort. Un cadre à trous 81 est placé par-dessus le support de socle 7, les trous 84 à travers le cadre 81 étant superposés par-dessus les ouvertures 13 dans le support de socle 7. Le diamètre des trous 84 est toutefois légèrement inférieur au diamètre des ouvertures 13, de manière à définir une butée 86 apte à retenir la plaquette de contact 46 par une saillie 464. La plaquette 46 est donc retenue de la même façon que la douille 83 sur la figure 16. Le cadre à trou 81 peut être fixé par exemple par collage ou vissage au support 7, après l'introduction des plaquettes 46.

La surface de contact 460 à l'extrémité de la plaquette est dans les exemples des figures 34 et 35 bombée de manière convexe et adaptée en particulier à des circuits de type Land Grid Array. Cette configuration permet d'assurer un contact optimal avec les pastilles de connexion planes 6 du circuit LGA, même lorsque l'axe de la plaquette de contact 46 n'est pas parfaitement perpendiculaire à la surface des pastilles 6. La surface 460 peut cependant être aussi beaucoup plus pointue, de manière à n'avoir un contact électrique qu'en un seul point, parfaitement plane ou bombée de manière concave selon le type de composant électrique que l'on désire connecter sur le socle. Les pastilles de contact 46 sont réalisées dans un matériau électriquement conducteur, de préférence en laiton, éventuellement en cuivre, en acier ou en métal précieux. Un avantage de l'invention est de pouvoir utiliser si nécessaire des plaquettes 46 dans un matériau différent du matériau utilisé pour le ressort 4 et du matériau utilisé pour la broche 3. Ainsi il est possible d'optimiser le choix des matériaux pour chaque élément selon les contraintes qu'il subit. Par exemple, il est possible de fabriquer des plaquettes 46 en or pour améliorer le contact et réduire les problèmes d'oxydation, et de choisir un autre matériau plus économique pour le ressort et la broche 3. De cette manière, la quantité d'or utilisée peut être minimisée.

En outre, il est possible de fabriquer des socles standards presque complets et de les adapter à divers types de circuits intégrés ou d'exigences de qualité simplement en les munissant de différents types de plaquettes de contact amovibles.

Les exemples ci-dessus concernent particulièrement des plaquettes de contact 46 utilisées pour faciliter le contact entre la broche 3 et des éléments de connexion 6 de type pattes de circuit intégré LGA. Des plaquettes supérieures 46 ou inférieures 47 peuvent cependant être utilisées pour faciliter la connexion avec des pattes de type BGA ou CGA par exemple, ou même pour faciliter le contact avec des pistes de circuit imprimé ou avec un câble multiconducteur. En cas de connexion d'un circuit intégré sur un circuit imprimé, il est ainsi possible d'employer des plaquettes de contact soit du côté circuit intégré, soit du côté circuit imprimé, soit simultanément des deux côtés. Les plaquettes de contact 46, 47 peuvent être soit simplement appuyées, soit soudées contre l'élément de connexion (piste ou patte) correspondant. Des plaquettes de contact 46, 47 peuvent être utilisées soit avec des socles à broches fixes, soit avec des socles à broches mobiles.

Nous avons décrit ci-dessus différentes variantes notamment pour la nature des broches (tiges 3 ou ressorts 3'), la position des éléments compressibles 4, 5 ou 40, leur nature (ressort spiral 4, 40 ou natte 5), la position des plaquettes de contact 46 et 47, le maintien longitudinal des broches à l'intérieur des ouvertures (butées 44, 45 ou plaques coulissantes 50, 51), les moyens d'appui du circuit intégré 1 contre le socle, le type de circuit (BGA, LGA, CGA, flip-chip, board-to-board par exemple), etc.. Bien qu'une énumération complète de toutes les combinaisons possibles de ces différentes variantes s'avérerait fastidieuse, l'homme du métier saura combiner et adapter sans difficultés ces diverses variantes.

## Revendications

1. Socle de connexion permettant de fixer de manière amovible un second composant électrique (1) sur un premier composant électrique (2) et de connecter électriquement ces deux composants électriques (1,2), les deux composants électriques comportant chacun une pluralité d'éléments de connexion (6; 6'; 6"; 8), comportant:
un support (7) destiné à être maintenu entre le premier composant électrique (2) et le deuxième composant électrique (1) et muni d'une pluralité d'ouvertures traversantes (13) disposées de la même façon que lesdits éléments de connexion,
une pluralité de broches conductrices (3; 3') s'étendant de manière sensiblement perpendiculaire au support, une extrémité de chaque broche étant destinée à être mise en contact électrique avec un élément de connexion (8) du premier composant électrique (2) tandis que l'autre extrémité est destinée à être mise en contact électrique avec un élément de connexion (6; 6'; 6") du deuxième composant électrique monté (1),
une desdites broches (3; 3') étant disposée dans chacune desdites ouvertures traversantes (13),
lesdites broches (3; 3') étant maintenues longitudinalement seulement de manière lâche à l'intérieur desdites ouvertures traversantes,
caractérisé en ce que:
un interstice (9; 41) est ménagé dans lesdites ouvertures traversantes (13) à l'extrémité de chacune desdites broches (3; 3') en sorte que lesdites broches (3; 3') sont en retrait par rapport à au moins une extrémité desdites ouvertures (13),
un élément compressible électriquement conducteur (4, 40, 5) est logé dans au moins un dudit ou desdits interstices (9; 41) de manière à permettre l'établissement d'un contact électrique entre chaque broche (3; 3') et l'élément de connexion correspondant (8) du premier composant électrique (2) et/ou l'élément de connexion correspondant (6; 6'; 6") correspondant du deuxième composant électrique (1) monté de manière amovible, la longueur dudit élément compressible (4, 40, 5) étant telle qu'il ne dépasse pas au-delà des ouvertures (13) du support lorsque lesdits composants électriques (1, 2) sont montés.

2. Socle selon la revendication 1, caractérisé en ce que chacune desdites broches (3) est constituée par un élément allongé sous forme de tige et de préférence en une seule pièce.

3. Socle selon la revendication 1, caractérisé en ce que chacune desdites broches (3') est constituée par un ressort spiral.

4. Socle selon l'une des revendications précédentes, caractérisé en ce qu'un au moins du ou des éléments compressibles électriquement conducteur est constitué par un ressort spiral (4; 40).

5. Socle selon la revendication 1, caractérisé en ce que chacune desdites broches est constituée par un ressort spiral (3'), un au moins du ou des éléments compressibles électriquement conducteur étant constitué par un ressort spiral (4; 40) de diamètre différent.

6. Socle selon la revendication précédente, caractérisé en ce que lesdites broches (3') et le ou les éléments compressibles électriquement conducteur (4, 40) associés sont constitués par un seul ressort.

7. Socle selon la revendication 4, caractérisé en ce que l'élément compressible électriquement conducteur inséré dans l'interstice (9) entre ladite broche et l'élément de connexion (6; 6'; 6" ) correspondant du deuxième composant électrique (1) monté est constitué par un ressort spiral (4), et en ce que l'extrémité dudit ressort spiral opposée à ladite broche (3; 3') est équipée d'une plaquette de contact (46).

8. Socle selon la revendication 4, caractérisé en ce que l'élément compressible électriquement conducteur inséré dans l'interstice (41) entre ladite broche et l'élément de connexion (8 ) correspondant du premier composant électrique (2) est constitué par un ressort spiral (40), et en ce que l'extrémité dudit ressort spirale opposée à ladite broche (3; 3') est équipée d'une plaquette de contact (47).

9. Socle selon la revendication 1, caractérisé en ce qu'un au moins un desdits éléments compressibles électriquement conducteur comporte une natte (5) élastique isolante électriquement dans laquelle sont incorporés une grande quantité de fils électriquement conducteurs fins (10) placés à faible distance les uns des autres.

10. Socle selon la revendication 9, caractérisé en ce que ladite natte (5) s'étend sur la totalité de la surface du support (7) traversée par lesdites broches (3; 3').

11. Socle selon la revendication 9, caractérisé en ce que l'extrémité desdites broches (3) orientée contre ladite natte élastique (5) présente une cavité avec un bord rond ou une couronne crantée avec plusieurs dents (12).

12. Socle selon la revendication 1, caractérisé en ce que le déplacement longitudinal desdites broches (3; 3') à l'intérieur desdites ouvertures traversantes est limité par des butées (44; 45) ménagée à l'intérieur desdites ouvertures traversantes.

13. Socle selon la revendication 1, caractérisé en ce que le déplacement longitudinal desdites broches (3; 3') à l'intérieur desdites ouvertures traversantes (13) est limité par frottement des broches contre les parois latérales desdites ouvertures traversantes (13).

14. Socle selon la revendication précédente, caractérisé en ce que ledit support (7) traversé par lesdites ouvertures traversantes (13) est constitué par plusieurs plaques superposées (50, 51) dont une au moins peut coulisser par rapport aux autres de manière à pouvoir ajuster ledit frottement des broches (3; 3') contre les parois latérales desdites ouvertures traversantes (13).

15. Socle selon la revendication précédente, caractérisé en ce que lesdites broches (3) sont soudées contre ledit premier composant électrique (2), et en ce qu'il est possible de retirer ledit support en faisant coulisser lesdites plaques superposées (50, 51) de manière à pouvoir observer ou réparer les soudures liant lesdites broches (3) audit premier composant électrique (2).

16. Socle selon la revendication 1, caractérisé en ce qu'il comporte des moyens d'appui dudit deuxième composant électrique (1) contre lesdites broches (6; 6'; 6"), lesdits moyens d'appui étant solidaires du socle et comportant une ou plusieurs vis (23) permettant d'exercer une pression contre la face supérieure du deuxième composant électrique (1).

17. Socle selon la revendication 1, caractérisé en ce qu'il comporte des moyens d'appui dudit deuxième composant électrique (1) contre lesdites broches (6; 6'; 6"), lesdits moyens d'appui étant solidaires du socle et comportant un élément de type ressort (17) permettant d'exercer une pression contre la face supérieure du deuxième composant électrique (1).

18. Socle selon la revendication 1, caractérisé en ce qu'il comporte des moyens d'appui (16, 17, 18, 23; 16, 23, 24, 29; 35, 36, 39) dudit deuxième composant électrique (1) contre lesdites broches (6; 6'; 6"), lesdits moyens d'appui étant solidaires du socle et comportant au moins une plaque de maintien rigide (17; 29; 35) permettant d'exercer une pression contre la face supérieure du deuxième composant électrique (1).

19. Socle selon la revendication 1, caractérisé en ce qu'il comporte des moyens d'appui (70, 71) dudit deuxième composant électrique (1) contre lesdites broches (6; 6'; 6"), lesdits moyens d'appui étant de type auto-bloquant.

20. Socle selon la revendication 1, caractérisé en ce qu'il comporte des moyens d'appui dudit deuxième composant électrique (1) contre lesdites broches (6; 6'; 6"), lesdits moyens d'appui étant solidaires du socle, la pression d'appui pouvant être ajustée.

21. Socle selon la revendication 2, caractérisé en ce que l'extrémité (14) desdites ouvertures traversantes (13) face au deuxième composant électrique (1) est formée de manière à permettre le guidage de la patte de connexion (6; 6'; 6") correspondante dudit deuxième composant électrique (1).

22. Socle selon la revendication 7, caractérisé en ce que la surface de contact (460) avec l'élément de connexion correspondant (6, 8) d'au moins certaines desdites plaquettes de contact (46, 47) est convexe.

23. Socle selon la revendication précédente, caractérisé en ce que lesdites plaquettes de contact (46) sont pointues, en sorte que ladite surface de contact (460) se réduit à un point.

24. Socle selon la revendication 7, caractérisé en ce que la surface de contact (460) avec l'élément de connexion correspondant (6, 8) d'au moins certaines desdites plaquettes de contact (46, 47) est plane.

25. Socle selon la revendication 7, caractérisé en ce que les flancs latéraux desdites plaquettes de contact (46) comportent une portion concave (463).

26. Socle selon la revendication 7, caractérisé en ce que lesdits éléments compressibles élastiquement conducteurs sont constitués par un ressort spiral (4, 40) et en ce que lesdites plaquettes de contact (46, 47) sont maintenues sur l'extrémité desdits éléments compressibles par une portion (461) insérée entre les spires du ressort (4, 40).

27. Socle selon la revendication précédente, dans lequel lesdites portions (461) insérées entre les spires du ressort comportent un collet (462) plus large que le reste de ladite portion.

28. Socle selon la revendication 7, caractérisé en ce que la surface de contact avec l'élément de connexion correspondant d'au moins certaines desdites plaquettes de contact (83) est convexe, et en ce qu'au moins une portion de chaque élément de connexion (6) peut être insérée dans ladite portion convexe desdites plaquettes de contact (83).

29. Socle selon l'une des revendications 7 ou 8, caractérisé en ce que lesdites plaquettes de contact (46, 47, 83) sont amovibles.

30. Socle selon l'une des revendications 7 ou 8, caractérisé en ce que lesdites plaquettes de contact (46, 47, 83) sont réalisées dans un matériau différent que lesdits éléments compressibles (4, 40) et/ou que lesdites broches (3, 3').

31. Socle selon l'une des revendications 7 ou 8, dans lequel lesdites plaquettes de contact (83) sont maintenues au moyen d'un cadre à douilles (81) placé sur ledit support de socle (7) et muni d'ouvertures traversantes (84) disposées de la même manière que lesdits éléments de connexion (6), une plaquette de contact (83) étant insérée dans chaque ouverture traversante (84) de manière à être mise en contact électrique avec lesdites broches (3; 3').

32. Arrangement d'un socle selon la revendication 1 et de deux composants électriques interconnectés par ledit socle, caractérisé en ce que ledit deuxième composant électrique (1) est constitué par un circuit intégré de type Ball Grid Array (BGA) ou flip-chip.

33. Arrangement d'un socle selon la revendication 1 et de deux composants électriques interconnectés par ledit socle, caractérisé en ce que ledit deuxième composant électrique (1) est constitué par un circuit intégré de type Land Grid Array (LGA).

34. Arrangement d'un socle selon la revendication 1 et de deux composants électriques interconnectés par ledit socle, caractérisé en ce que ledit deuxième composant électrique (1) est constitué par un circuit intégré de type Column Grid Array (CGA).

35. Arrangement selon la revendication précédente, caractérisé en ce que le socle comporte en outre un cadre à douilles (81) placé sur ledit support de socle (7) et muni d'ouvertures traversantes (84) disposées de la même manière que lesdites pattes de connexion (6'), une douille métallique (83) étant insérée dans chaque ouverture traversante (84) de manière à être mise en contact électrique avec lesdites broches (3; 3'), une patte (6') dudit deuxième composant électrique (1) mis en place étant insérée dans chacune desdites douilles (83).

36. Arrangement d'un socle selon la revendication 1 et de deux composants électriques interconnectés par ledit socle, caractérisé en ce que lesdits composants électriques (1 ; 2) sont constitués chacun par une plaque de circuit imprimé, ledit socle permettant d'effectuer une liaison carte-à-carte entre les pistes des deux circuits imprimés.

37. Arrangement d'un socle selon la revendication 1 et de deux composants électriques à interconnecter, caractérisé en ce qu'il comporte des moyens d'appui (60, 63, 64, 67) dudit deuxième composant électrique (1) contre lesdites broches (6; 6'; 6"), lesdits moyens d'appui comportant un radiateur (60) vissé au-dessus dudit deuxième composant électrique sur une pièce (63) solidaire du socle ou du premier composant électrique (2) et permettant d'exercer une pression contre la face supérieure du deuxième composant électrique (1).

## Patentansprüche

1. Kontaktsockel zum lösbaren Befestigen eines zweiten elektrischen Bauteiles (1) auf einem ersten elektrischen Bauteil (2) und zur elektrischen Verbindung dieser zwei elektrischen Bauteile (1, 2), beide elektrische Bauteile mit einer Vielzahl von Verbindungselementen (6; 6'; 6"; 8) versehen, enthaltend:
einen Tragteil (7), zwischen dem ersten elektrischen Bauteil (2) und dem zweiten elektrischen Bauteil (1) befestigt und mit einer Vielzahl von durchgehenden Bohrungen (13) versehen, welche in der gleichen Weise wie die benannten Verbindungselemente angeordnet sind,
eine Vielzahl von leitenden Kontaktstiften (3; 3'), welche sich etwa rechtwinklig vom Tragteil wegerstrecken, wobei ein Ende eines jeden Kontaktstiftes zum Herstellen einer elektrischen Verbindung mit einem Verbindungselement (8) des ersten elektrischen Bauteiles (2), während das andere Ende zum Herstellen einer elektrischen Verbindung mit einem Verbindungselement (6; 6'; 6") des montierten zweiten elektrischen Bauteiles (1) vorgesehen ist,
je einer der benannten Kontaktstifte (3, 3') in jeder der benannten durchgehenden Bohrungen (13) angelegt ist,
die benannten Kontaktstifte (3; 3') längs nur locker im Inneren der benannten durchgehenden Bohrungen festgehalten werden,
dadurch gekennzeichnet, dass
ein Abstand (9; 41) in den benannten durchgehenden Bohrungen (13) am Ende jedes benannten Kontaktstiftes (3; 3') angelegt ist, so dass die benannten Kontaktstifte (3; 3') in Bezug auf je mindestens ein Ende der benannten Bohrungen (13) zurückstehend angeordnet sind,
ein zusammendrückbares elektrisch leitendes Element (4, 40, 5) in mindestens einem des benannten Abstandes oder der benannten Abstände (9; 41) untergebracht ist, so dass eine elektrische Verbindung zwischen jedem Kontaktstift (3; 3') und dem entsprechenden Verbindungselement (8) des ersten elektrischen Bauteiles (2) und/oder dem entsprechenden Verbindungselement (6; 6'; 6") des lösbar montierten zweiten elektrischen Bauteiles (1) hergestellt werden kann, wobei die Länge des benannten zusammendrückbaren Elementes (4, 40, 5) so ist, dass es nicht über die Bohrungen (13) des Tragteiles herausragt, wenn die benannten elektrischen Bauteile (1, 2) befestigt sind.

2. Sockel nach Anspruch 1, dadurch gekennzeichnet, dass jeder der benannten Kontaktstifte (3) aus einem länglichen Element in Form einer Stange und vorzugsweise einstückig hergestellt ist.

3. Sockel nach Anspruch 1, dadurch gekennzeichnet, dass jeder der benannten Kontaktstifte (3') aus einer Spiralfeder besteht.

4. Sockel nach einem der vorhergehenden Ansprüche, dadurch gekennzeichnet, dass mindestens eines des zusammendrückbaren elektrisch leitenden Kontaktelementes oder der zusammendrückbaren elektrisch leitenden Kontaktelemente aus einer Spiralfeder (4; 40) besteht.

5. Sockel nach Anspruch 1, dadurch gekennzeichnet, dass jeder der benannten Kontaktstifte aus einer Spiralfeder (3') besteht, wobei mindestens eines des zusammendrückbaren elektrisch leitenden Kontaktelementes oder der zusammendrückbaren elektrisch leitenden Kontaktelemente aus einer Spiralfeder (4; 40) mit unterschiedlichem Durchmesser besteht.

6. Sockel nach dem vorhergehenden Anspruch, dadurch gekennzeichnet, dass die benannten Kontaktstifte (3') und das assoziierte zusammendrückbare elektrisch leitende Kontaktelement oder die assoziierten zusammendrückbaren elektrisch leitenden Kontaktelemente (4, 40) aus einer einzigen Feder besteht bzw. bestehen.

7. Sockel nach Anspruch 4, dadurch gekennzeichnet, dass das im Abstand (9) zwischen dem benannten Kontaktstift und dem Verbindungselement (6; 6'; 6"), welches dem montierten zweiten elektrischen Bauteil (1) entspricht, eingeführte zusammendrückbare elektrisch leitende Kontaktelement aus einer Spiralfeder (4) besteht, und dass das Ende der benannten Spiralfeder gegenüber dem benannten Kontaktstift (3; 3') mit einer Leiterplatte (46) versehen ist.

8. Sockel nach Anspruch 4, dadurch gekennzeichnet, dass das im Abstand (41) zwischen dem benannten Kontaktstift und dem Verbindungselement (8), welches dem ersten elektrischen Bauteil (2) entspricht, eingeführte zusammendrückbare elektrisch leitende Kontaktelement aus einer Spiralfeder (40) besteht, und dass das Ende der benannten Spiralfeder gegenüber dem benannten Kontaktstift (3; 3') mit einer Leiterplatte (47) versehen ist.

9. Sockel nach Anspruch 1, dadurch gekennzeichnet, dass mindestens eines der benannten zusammendrückbaren elektrisch leitenden Kontaktelemente eine elektrisch isolierende gummielastische Matte (5) umfasst, in welcher eine Vielzahl dünner elektrisch leitender Drähte (10), die in einem kleinen Abstand voneinander angeordnet sind, vorhanden sind.

10. Sockel nach Anspruch 9, dadurch gekennzeichnet, dass sich die benannte Matte (5) über die gesamte Fläche des durch die benannten Kontaktstifte (3; 3') durchquerten Tragteiles (7) erstreckt.

11. Sockel nach Anspruch 9, dadurch gekennzeichnet, dass das der elastischen Matte (5) zugewandte Ende der benannten Kontaktstifte (3) eine Pfanne mit einem kreisförmigen Rand oder ein kronenförmiges Gebilde mit mehreren Zacken (12) aufweist.

12. Sockel nach Anspruch 1, dadurch gekennzeichnet, dass die Längsverschiebung der benannten Kontaktstifte (3; 3') im Inneren der benannten durchgehenden Bohrungen durch im Inneren der benannten durchgehenden Bohrungen angebrachte Anschläge (44, 45) eingeschränkt ist.

13. Sockel nach Anspruch 1, dadurch gekennzeichnet, dass die Längsverschiebung der benannten Kontaktstifte (3; 3') im Inneren der benannten durchgehenden Bohrungen (13) durch die Reibung der Kontaktstifte gegen die Seitenwände der benannten durchgehenden Bohrungen (13) eingeschränkt ist.

14. Sockel nach dem vorhergehenden Anspruch, dadurch gekennzeichnet, dass der benannte durch die benannten durchgehenden Bohrungen (13) durchquerte Tragteil (7) mehrere übereinanderliegende Platten (50, 51) umfasst, wovon mindestens eine in Bezug auf die anderen gleitend verschoben werden kann, so dass die benannte Reibung der Kontaktstifte (3; 3') gegen die Seitenwände der benannten durchgehenden Bohrungen (13) reguliert werden kann.

15. Sockel nach dem vorhergehenden Anspruch, dadurch gekennzeichnet, dass die benannten Kontaktstifte (3) gegen den benannten ersten elektrischen Bauteil (2) geschweisst sind, und dass es möglich ist, den benannten Tragteil durch das gleitend Verschieben der übereinanderliegenden Platten (50, 51) zu entfernen, so dass die Schweissungen, welche die benannten Kontaktstifte (3) mit dem ersten elektrischen Bauteil (2) verbinden, beobachtet oder repariert werden können.

16. Sockel nach Anspruch 1, dadurch gekennzeichnet, dass er Druckmittel des benannten zweiten elektrischen Bauteiles (1) gegen benannte Verbindungselemente (6; 6'; 6") aufweist, wobei die benannten Druckmittel solidarisch mit dem Sockel sind und dass sie eine oder mehrere Schrauben (23) enthalten, welche es erlauben, einen Druck gegen die Oberwand des zweiten elektrischen Bauteiles (1) auszuüben.

17. Sockel nach Anspruch 1, dadurch gekennzeichnet, dass er Druckmittel des benannten zweiten elektrischen Bauteiles (1) gegen benannte Verbindungselemente (6; 6'; 6") aufweist, wobei die benannten Druckmittel solidarisch mit dem Sockel sind und dass sie ein Element des Types Feder enthalten, welches es erlaubt, einen Druck gegen die Oberwand des zweiten elektrischen Bauteiles (1) auszuüben.

18. Sockel nach Anspruch 1, dadurch gekennzeichnet, dass er Druckmittel (16, 17, 18, 23; 16, 23, 24, 29, 35, 36, 39) des benannten zweiten elektrischen Bauteiles (1) gegen benannte Verbindungselemente (6; 6'; 6")enthält, wobei die benannten Druckmittel solidarisch mit dem Sockel sind und mindestens eine nicht dehnbare Halterplatte (17; 29; 35) enthalten, welche es erlaubt, einen Druck gegen die Oberwand des zweiten elektrischen Bauteiles (1) auszuüben.

19. Sockel nach Anspruch 1, dadurch gekennzeichnet, dass er Druckmittel (70, 71) des benannten zweiten elektrischen Bauteiles (1) gegen die benannten Verbindungselemente (6; 6'; 6") enthält, wobei benannte Druckmittel des Types selbsthemmend sind.

20. Sockel nach Anspruch 1, dadurch gekennzeichnet, dass er Druckmittel des benannten zweiten elektrischen Bauteiles (1) gegen benannte Verbindungselemente (6; 6'; 6") enthält, wobei benannte Druckmittel solidarisch mit dem Sockel sind und die Druckkraft einstellbar ist.

21. Sockel nach Anspruch 2, dadurch gekennzeichnet, dass das Ende (14) der benannten durchgehenden Bohrungen (13) gegenüber dem zweiten elektrischen Bauteil (1) so gebaut ist, dass es die Führung der entsprechenden Verbindungsklammer (6; 6'; 6") des zweiten elektrischen Bauteiles (1) erlaubt.

22. Sockel nach Anspruch 7, dadurch gekennzeichnet, dass die Kontaktfläche (460) mit dem entsprechenden Verbindungselement (6, 8) wenigstens bestimmter benannter Leiterplatten (46, 47) konvex ist.

23. Sockel nach dem vorhergehenden Anspruch, dadurch gekennzeichnet, dass die benannten Leiterplatten (46) spitz sind, so dass die benannte Kontaktfläche (460) zu einem Punkt reduziert wird.

24. Sockel nach Anspruch 7, dadurch gekennzeichnet, dass die Kontaktfläche (460) mit dem entsprechenden Verbindungselement (6, 8) wenigstens bestimmter benannter Leiterplatten (46, 47) eben ist.

25. Sockel nach Anspruch 7, dadurch gekennzeichnet, dass die Seitenflanken der benannten Leiterplatten (46) einen konkaven Teil (463) aufweisen.

26. Sockel nach Anspruch 7, dadurch gekennzeichnet, dass die benannten zusammendrückbaren elektrisch leitenden Kontaktelemente aus einer Spiralfeder (4, 40) bestehen, und dass die benannten Leiterplatten (46, 47) auf dem Ende der benannten zusammendrückbaren Elemente durch einen zwischen den Spiralen der Feder (4, 40) eingeführten Teil (461) gehalten werden.

27. Sockel nach dem vorhergehendem Anspruch, dadurch gekennzeichnet, dass die zwischen den Spiralfedern eingeführten benannten Teile (461) einen Rand (462) grösser als der Rest des benannten Teiles aufweisen.

28. Sockel nach Anspruch 7, dadurch gekennzeichnet, dass die Kontaktfläche mit dem entsprechenden Verbindungselement wenigstens einigen benannten Leiterplatten (83) konvex ist und dass wenigstens ein Teil jedes Verbindungselementes (6) in den benannten konvexen Teil benannter Leiterplatten (83) eingeführt werden kann.

29. Sockel nach einem der Ansprüche 7 oder 8, dadurch gekennzeichnet, dass benannte Leiterplatten (46, 47, 83) lösbar sind.

30. Sockel nach einem der Ansprüche 7 oder 8, dadurch gekennzeichnet, dass benannte Leiterplatten (46, 47, 83) aus einem Material bestehen, das sich von demjenigen der benannten zusammendrückbaren Elemente (4, 40) und/oder der benannten Kontaktstifte (3; 3') unterscheidet.

31. Sockel nach einem der Ansprüche 7 oder 8, dadurch gekennzeichnet, dass die benannten Leiterplatten (83) mittels eines Ringrahmens (81) gehalten werden, welcher auf dem benannten Tragteil (7) plaziert ist und durchgehende Bohrungen (84) aufweist, welche gleich den benannten Verbindungselementen (6) angeordnet sind, wobei eine Leiterplatte (83) in jede durchgehende Bohrung (84) eingeführt wird, so dass eine elektrische Verbindung mit den benannten Kontaktstiften (3; 3') hergestellt werden kann.

32. Anordnung eines Sockels nach dem Anspruch 1 und zweier mit benanntem Sockel verbundenen elektrischen Bauteile, dadurch gekennzeichnet, dass das benannte zweite elektrische Bauteil (1) aus einem integrierten Schaltkreis vom Typ Ball Grid Array (BGA) oder flip-chip besteht.

33. Anordnung eines Sockels nach dem Anspruch 1 und zweier mit benanntem Sockel verbundenen elektrischen Bauteile, dadurch gekennzeichnet, dass das benannte zweite elektrische Bauteil (1) aus einem integrierten Schaltkreis vom Typ Land Grid Array (LGA) besteht.

34. Anordnung eines Sockels nach dem Anspruch 1 und zweier mit benanntem Sockel verbundenen elektrischen Bauteile, dadurch gekennzeichnet, dass das benannte zweite elektrische Bauteil (1) aus einem integrierten Schaltkreis vom Typ Column Grid Array (CGA) besteht.

35. Anordnung nach dem vorhergehenden Anspruch, dadurch gekennzeichnet, dass der Sockel unter anderem einen Ringrahmen (81) aufweist, welcher auf dem Tragteil (7) plaziert ist und durchgehenden Bohrungen (84) aufweist, welche gleich den benannten Verbindungselementen (6) angeordnet sind, wobei eine Metallbuchse (83) in jede durchgehende Bohrung (84) eingeführt wird, so dass eine elektrische Verbindung mit den benannten Kontaktstiften (3; 3') hergestellt werden kann, wobei eine Klammer (6') des benannten montierten zweiten elektrischen Bauteiles (1) in jede der benannten Metallbuchsen (83) eingeführt wird.

36. Anordnung eines Sockels nach dem Anspruch 1 und zweier mit benanntem Sockel verbundenen elektrischen Bauteile, dadurch gekennzeichnet, dass jedes der benannten elektrischen Bauteile (1; 2) jeweils aus einem gedruckten Schaltkreis besteht, wobei der benannte Sockel eine Karte zu Karte Verbindung zwischen den Bahnen beider gedruckten Schaltkreise erlaubt.

37. Anordnung eines Sockels nach dem Anspruch 1 und zweier zu verbindenden elektrischen Bauteile, dadurch gekennzeichnet, dass er Druckmittel (60, 63, 64, 67) des benannten zweiten elektrischen Bauteiles (1) gegen die benannten Verbindungselemente (6, 6', 6") des benannten zweiten elektrischen Bauteiles (1) enthält, wobei jene benannten Druckmittel einen Radiator (60) enthalten, welcher über das benannte zweite elektrische Bauteil auf einen mit dem Sockel oder dem ersten elektrischen Bauteil (2) solidarischen Teil (63) angeschraubt ist, und wobei jene benannten Druckmittel es erlauben, einen Druck gegen die Oberseite des zweiten elektrischen Bauteiles (1) auszuüben.

## Claims

1. Connecting base for detachably fastening a second electrical component (1) on a first electrical component (2) and for electrically connecting these two electrical components (1,2), both electrical components including a plurality of connecting elements (6; 6'; 6"; 8), comprising
a support part (7) destined to be maintained between the first electrical component (2) and the second electrical component (1) and provided with a plurality of continuous bores (13) that are arranged in the same manner as said connecting elements,
a plurality of conductive contact pins (3; 3') that extend from the support part at about a right angle, an extremity of each contact pin being destined to be brought into electric contact with a connecting element (8) of the first electrical component (2), whereas the other extremity is destined to be brought into electric contact with a connecting element (6; 6'; 6") of the mounted second electrical component (1),
one of said contact pins (3; 3') being disposed in each one of said continuous bores (13),
said contact pins (3; 3') being fastened longitudinally only loosely inside said continuous bores,
characterised in that,
an interstice (9; 41) is provided in said continuous bores (13) at the extremity of each of said contact pins (3; 3') so that said contact pins (3; 3') are set back relative to at least one extremity of said bores (13),
a compressible, electrically conductive element (4, 40, 5) is lodged in at least one of said interstice or interstices (9; 41), so as to enable an electric contact to be established between each contact pin (3; 3') and the corresponding connecting element (8) of the first electrical component (2) and/or the corresponding connecting element (6; 6'; 6") of the second electrical component (1) detachably fastened, the length of said compressible element (4, 40, 5) being such that it does not protrude beyond the bores (13) of the support part when said electrical components (1, 2) are mounted.

2. Connecting base according to claim 1, characterised in that each of said contact pins (3) consists of an elongated element in the shape of a rod and preferably made in one piece.

3. Connecting base according to claim 1, characterised in that each of said contact pins (3') is constituted of a coil spring.

4. Connecting base according to one of the preceding claims, characterised in that at least one of the compressible, electrically conductive contact element or elements is constituted of a coil spring (4; 40).

5. Connecting base according to claim 1, characterised in that each of said contact pins is constituted of a coil spring (3'), at least one of the compressible, electrically conductive contact element or elements being constituted of a coil spring (4; 40) of a different diameter.

6. Connecting base according to the preceding claim, characterised in that said contact pins (3') and the compressible, electrically conductive contact element or elements (4, 40) associated are constituted of a single spring.

7. Connecting base according to claim 4, characterised in that the compressible, electrically conductive element inserted in the interstice (9) between said contact pin and the corresponding connecting element (6; 6'; 6") of the mounted second electrical component (1) is constituted of a coil spring (4) and in that the extremity of said coil spring opposite said contact pin (3; 3') is fitted with a contact plate (46).

8. Connecting base according to claim 4, characterised in that the compressible, electrically conductive element inserted in the interstice (41) between said contact pin and the corresponding connecting element (8) of the mounted first electrical component (2) is constituted of a coil spring (40) and in that the extremity of said coil spring opposite said contact pin (3; 3') is fitted with a contact plate (47).

9. Connecting base according to claim 1, characterised in that at least one of said compressible, electrically conductive contact element or elements includes an electrically insulating rubber-elastic mat (5) in which there is a plurality of thin, electrically conductive wires (10) spaced close to one another.

10. Connecting base according to claim 9, characterised in that said mat (5) extends over the entire surface of support part (7) traversed by said contact pins (3; 3').

11. Connecting base according to claim 9, characterised in that the extremity of said contact pins (3) oriented towards said rubber-elastic mat (5) has a dish with a circular rim or a crown-shaped structure with several teeth (12).

12. Connecting base according to claim 1, characterised in that the longitudinal displacement of said contact pins (3; 3') inside said continuous bores is restricted by stops (44; 45) provided inside said continuous bores.

13. Connecting base according to claim 1, characterised in that the longitudinal displacement of said contact pins (3; 3') inside said continuous bores (13) is restricted by friction of the contact pins against the lateral sides of said continuous bores (13).

14. Connecting base according to the preceding claim, characterised in that said support part (7) traversed by said continuous bores (13) is constituted of several superimposed plates (50, 51), at least one of which can slide relative to the others so as to enable said friction of the contact pins (3; 3') against the lateral sides of said continuous bores (13) to be adjusted.

15. Connecting base according to the preceding claim, characterised in that said contact pins (3) are welded against said first electrical component (2) and in that it is possible to withdraw said support part by sliding said superimposed plates (50, 51) so as to be able to observe or repair the weldings linking said contact pins (3) to the first electrical component (2).

16. Connecting base according to claim 1, characterised in that it comprises pressuring means of said second electrical component (1) against said contact pins (6; 6'; 6"), said pressuring means being solidly attached to the connecting base and comprising one or several screws (23) enabling a pressure to be exerted on the upper side of the second electrical component (1).

17. Connecting base according to claim 1, characterised in that it comprises pressuring means of said second electrical component (1) against said contact pins (6; 6'; 6"), said pressuring means being solidly attached to the connecting base and comprising a spring type element (17) enabling a pressure to be exerted on the upper side of the second electrical component (1).

18. Connecting base according to claim 1, characterised in that it comprises pressuring means (16, 17, 18, 23; 16, 23, 24, 29; 35, 36, 39) of said second electrical component (1) against said contact pins (6; 6'; 6"), said pressuring means being solidly attached to the connecting base and comprising at least one rigid holding plate (17; 29; 35) enabling a pressure to be exerted on the upper side of the second electrical component (1).

19. Connecting base according to claim 1, characterised in that it comprises pressuring means (70, 71) of said second electrical component (1) against said contact pins (6; 6'; 6"), said pressuring means being of the self-locking type.

20. Connecting base according to claim 1, characterised in that it comprises pressuring means of said second electrical component (1) against said contact pins (6; 6'; 6"), said pressuring means being solidly attached to the connecting base, the pressure being adjustable.

21. Connecting base according to claim 2, characterised in that the extremity (14) of said continuous bores (13) opposite the second electrical component (1) is shaped so as to enable the corresponding connecting pin (6; 6'; 6") of said second electrical component (1) to be guided.

22. Connecting base according to claim 7, characterised in that the contact surface (460) with the corresponding connecting element (6, 8) of at least some of said contact plates (46, 47) is convex.

23. Connecting base according to the preceding claim, characterised in that said contact plates (46) are pointed, so that that said contact surface (460) is reduced to a point.

24. Connecting base according to claim 7, characterised in that the contact surface (460) with the corresponding connecting element (6, 8) of at least some of said contact plates (46, 47) is plane.

25. Connecting base according to claim 7, characterised in that the lateral sides of said contact plates (46) comprise a concave portion (463).

26. Connecting base according to claim 7, characterised in that said compressible, electrically conductive contact elements are constituted of a coil spring (4, 40) and in that said contact plates (46, 47) are held on the extremity of said compressible elements by a portion (461) inserted between the coils of the spring (4, 40).

27. Connecting base according to the preceding claim, characterised in that said portions (461) inserted between the coils of the spring comprise a collar that is wider than the rest of said portion.

28. Connecting base according to claim 7, characterised in that the contact surface with the corresponding connecting element of at least several of said contact plates (83) is convex and in that at least a portion of each connecting element (6) can be inserted in said convex portion of said contact plates (83).

29. Connecting base according to one of the claims 7 or 8, characterised in that said contact plates (46, 47, 83) are removable.

30. Connecting base according to one of the claims 7 or 8, characterised in that said contact plates (46, 47, 83) are made of a material different from that of said compressible elements (4, 40) and/or of said contact pins (3, 3').

31. Connecting base according to one of the claims 7 or 8, characterised in that said contact plates (83) are held by a collet frame placed on said support part (7) and provided with continuous bores (84) arranged in the same manner as said connecting elements (6), a contact plate (83) being inserted into each continuous bore (84) so that it is brought into electric contact with said contact pins (3; 3').

32. Arrangement of a connecting base according to claim 1 and of two electrical components interconnected through said connecting base, characterised in that said second electrical component (1) consists of an integrated circuit of the Ball Grid Array (BGA) type or flip-chip type.

33. Arrangement of a connecting base according to claim 1 and of two electrical components interconnected through said connecting base, characterised in that said second electrical component (1) consists of an integrated circuit of the Land Grid Array (LGA) type.

34. Arrangement of a connecting base according to claim 1 and of two electrical components interconnected through said connecting base, characterised in that said second electrical component (1) consists of an integrated circuit of the Column Grid Array (CGA) type.

35. Arrangement according to the preceding claim, characterised in that the connecting base further comprises a collet frame (81) placed on said support frame (7) and provided with continuous bores (84) arranged in the same manner as said connecting pins (6'), a metallic sleeve (83) being inserted into each continuous bore (84) so that it is brought into electric contact with said contact pins (3; 3'), a pin (6') of said mounted second electrical component (1) being inserted into each of said sleeves (83).

36. Arrangement of a connecting base according to claim 1 and of two electrical components interconnected through said connecting base, characterised in that said electrical components (1; 2) are constituted each by a printed circuit board, said connecting base enabling a card-to-card link between the tracks of the two printed circuits.

37. Arrangement of a connecting base according to claim 1 and of two electrical components to be interconnected, characterised in that it comprises pressuring means (60, 63, 64, 67) of said second electrical component (1) against said contact pins (6; 6'; 6"), said pressuring means including a radiator (60) screwed over said second electrical component on an element (63) solidly attached to the connecting base or to the first electrical component (2) and enabling a pressure to be exerted against the upper side of the second electrical component (1).
